# EUROPEAN PATENT APPLICATION

(11) **EP 4 803 302 A1**
(43) Date of publication of application: **09.09.2026**
(21) Application number: 24885745.0
(22) Date of filing: 30.10.2024
(51) Int. Cl.: B32B 15/08, B32B 15/092, C08K 3/28, C08K 3/38, C08L 101/00, H01L 23/36

(54) **JOINED BODY, JOINING SHEET, AND METHOD FOR PRODUCING JOINED BODY**

(30) Priority: 31.10.2023 JP 2023186646; 31.10.2023 JP 2023186647; 14.12.2023 JP 2023210671
(71) Applicant: Mitsubishi Chemical Corporation, Tokyo 100-8251 (JP)
(72) Inventor: KIMURA, Akinori, Tokyo 100-8251 (JP); TANAKA, Toshiyuki, Tokyo 100-8251 (JP); IMAI, Ayano, Tokyo 100-8251 (JP)
(74) Representative: Hoffmann Eitle
(86) International application number: PCT/JP2024/038654
(87) International publication number: WO 2025/094978

(57) **Abstract**

Provided is a bonded body including an upper metal-containing member 2 and a lower metal-containing member 3 bonded, respectively, to upper and lower surfaces of a bonding sheet 1, which can suppress cracks and deformations in the bonding sheet 1 even when stress is applied to the bonding sheet 1 due to a difference in expansion coefficients between the members caused by temperature changes.

The upper metal-containing member 2 and the lower metal-containing member 3 each have a metal portion in a bonding surface with the bonding sheet 1, the bonding sheet 1 is a cured product of a thermosetting resin composition containing a thermosetting resin and an inorganic filler, the entire upper surface of the bonding sheet 1 is bonded to the upper metal-containing member 2, the entire lower surface of the bonding sheet 1 is bonded to the lower metal-containing member 3, and when the bonding sheet 1 is viewed in cross-section, a value of P_{1A}/P_{1B} is more than 1.10, where P_{1A} is a resin area ratio in an end region 1A extending 300 µm inward from either the left or right end of the bonding sheet 1, and P_{1B} is a resin area ratio in a central region 1B other than the end region 1A.

## Description

### TECHNICAL FIELD

The present invention relates to a bonded body, such as a power semiconductor device, including an upper metal-containing member and a lower metal-containing member bonded, respectively, to upper and lower surfaces of a bonding sheet, a bonding sheet used therein, and a method for producing the bonded body.

### BACKGROUND ART

Among semiconductor devices, those that control or convert electric power, such as power supplies, are called "power semiconductor devices".

Power semiconductor devices with mounted electronic components are known to have a configuration in which electronic components, such as semiconductor elements, are arranged on the central upper surface of a metal base plate (heat-dissipating plate) via an insulating substrate, a heat-dissipating member, such as a metal member, is further arranged on the electronic components, and these electronic components and the heat-dissipating member are enclosed and sealed with a synthetic resin (see Patent Literatures 1 to 4).

Conventionally, ceramic substrates having high thermal conductivity, such as alumina substrates and aluminum nitride substrates, have been used for the insulating substrate because they can achieve both thermal conductivity and insulating properties. However, the ceramic substrates have issues such as cracking easily upon impact and being difficult to thin and downsize.

Accordingly, thermally conductive sheets using a thermosetting resin, such as epoxy resin, and an inorganic filler have been proposed as the insulating substrate.

With regard to the sheets using a thermosetting resin and an inorganic filler, for example, Patent Literature 5 discloses a sealing resin sheet that contains alumina particles and boron nitride in addition to a thermosetting resin and a thermoplastic resin, and has a thermal conductivity in the sheet thickness direction of 3 W/m·K or more after thermal curing.

Furthermore, Patent Literature 6 proposes a heat-dissipating resin sheet containing epoxy resin with a Tg of 60°C or lower and boron nitride, wherein the boron nitride content is 30% by volume or more and 60% by volume or less.

### CITATION LIST

### PATENT LITERATURE

Patent Literature 1: JP2000-323593A
Patent Literature 2: JP2004-103846A
Patent Literature 3: WO2016/162991
Patent Literature 4: JP2018-074089A
Patent Literature 5: JP2017-036415A
Patent Literature 6: WO2019/189746

### SUMMARY OF THE INVENTION

### PROBLEM TO BE SOLVED BY THE INVENTION

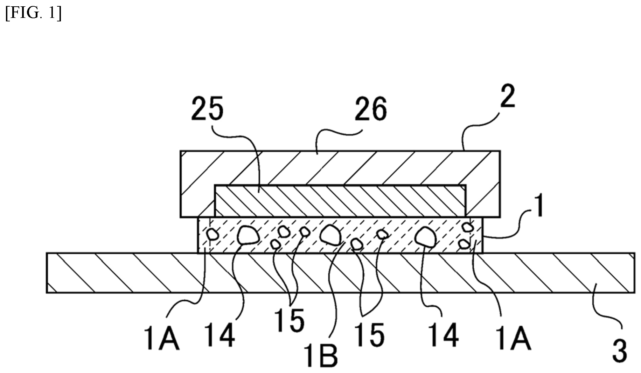

As shown in FIG. 1, in a bonded body including an upper metal-containing member 2 and a lower metal-containing member 3 bonded, respectively, to the upper and lower surfaces of a bonding sheet 1 (corresponding to the insulating substrate), it has been found that, when stress is applied to the bonding sheet 1 due to a difference in expansion coefficients between the members caused by temperature changes, pressure is concentrated locally at the end of the bonding sheet 1, causing cracks and deformations within the bonding sheet 1.

Therefore, an object of the present invention is to provide a novel bonded body that includes an upper metal-containing member 2 and a lower metal-containing member 3 bonded, respectively, to the upper and lower surfaces of a bonding sheet 1, and that can suppress cracks and deformations in the bonding sheet 1 even when stress is applied to the bonding sheet 1 due to a difference in expansion coefficients between the members caused by temperature changes. The present invention also provides a bonding sheet used in the bonded body and a method for producing the bonded body.

### MEANS FOR SOLVING PROBLEM

The bonded body, the bonding sheet used therein, and the method for producing the bonded body proposed by the present invention have the following configurations in order to solve the above problem.
[1] A first aspect of the present invention is a bonded body including an upper metal-containing member 2 and a lower metal-containing member 3 bonded, respectively, to upper and lower surfaces of a bonding sheet 1, wherein
   the upper metal-containing member 2 and the lower metal-containing member 3 each have a metal portion in a bonding surface with the bonding sheet 1,
   the bonding sheet 1 is a cured product of a thermosetting resin composition containing a thermosetting resin and an inorganic filler,
   the entire upper surface of the bonding sheet 1 is bonded to the upper metal-containing member 2, the entire lower surface of the bonding sheet 1 is bonded to the lower metal-containing member 3, and when the bonding sheet 1 is viewed in cross-section, a value of P_{1A}/P_{1B} is more than 1.10, where P_{1A} is a resin area ratio in an end region 1A extending 300 µm inward from either the left or right end of the bonding sheet 1, and P_{1B} is a resin area ratio in a central region 1B other than the end region 1A.
[2] A second aspect of the present invention is a bonded body including an upper metal-containing member 2 and a lower metal-containing member 3 bonded, respectively, to upper and lower surfaces of a bonding sheet 1, wherein
   the upper metal-containing member 2 and the lower metal-containing member 3 each have a metal portion in a bonding surface with the bonding sheet 1,
   the bonding sheet 1 is a cured product of a thermosetting resin composition containing a thermosetting resin and an inorganic filler,
   the entire upper surface of the bonding sheet 1 is bonded to the upper metal-containing member 2, the entire lower surface of the bonding sheet 1 is bonded to the lower metal-containing member 3, and when the bonding sheet 1 is viewed in cross-section, a value of S_{1A}/S_{1B} is more than 1, where S_{1A} is a void area ratio in an end region 1A extending 300 µm inward from either the left or right end of the bonding sheet 1, and S_{1B} is a void area ratio in a central region 1B other than the end region 1A.
[3] A third aspect of the present invention is a bonded body including an upper metal-containing member 2 and a lower metal-containing member 3 bonded, respectively, to upper and lower surfaces of a bonding sheet 1, wherein
   the upper metal-containing member 2 and the lower metal-containing member 3 each have a metal portion in a bonding surface with the bonding sheet 1,
   the bonding sheet 1 is a cured product of a thermosetting resin composition containing a thermosetting resin and an inorganic filler,
   the entire upper surface of the bonding sheet 1 is bonded to the upper metal-containing member 2, the entire lower surface of the bonding sheet 1 is bonded to the lower metal-containing member 3, and when the bonding sheet 1 is viewed in cross-section, a value of L_{1A}/L_{1B} is more than 2, where L_{1A} is a void average size in an end region 1A extending 300 µm inward from either the left or right end of the bonding sheet 1, and L_{1B} is a void average size in a central region 1B other than the end region 1A.
[4] A fourth aspect of the present invention is the bonded body according to any one of the first to third aspects, wherein the bonding sheet 1 is directly bonded to the upper metal-containing member 2, and the bonding sheet 1 is directly bonded to the lower metal-containing member 3.
[5] A fifth aspect of the present invention is the bonded body according to any one of the first to fourth aspects, wherein the upper metal-containing member 2 has a configuration in which a lower surface of a sheet or plate-shaped metal portion 25 is exposed in the bonding surface with the bonding sheet 1, and the metal portion 25 is covered and sealed with a resin 26.
[6] A sixth aspect of the present invention is the bonded body according to any one of the first to fifth aspects, wherein the lower metal-containing member 3 has a plate-shaped or sheet-shaped metal body in the bonding surface with the bonding sheet 1.
[7] A seventh aspect of the present invention is the bonded body according to any one of the first to sixth aspects, wherein the bonding sheet 1 has a thermal conductivity in the thickness direction of 10 W/m·K or more.
[8] An eighth aspect of the present invention is the bonded body according to any one of the first to seventh aspects, wherein the bonding sheet 1 has a dielectric breakdown voltage of 5 kV or more.
[9] A ninth aspect of the present invention is the bonded body according to any one of the first to eighth aspects, wherein the metal portions of the upper metal-containing member 2 and the lower metal-containing member 3 are composed of a material containing copper or aluminum.
[10] A tenth aspect of the present invention is the bonded body according to any one of the first to ninth aspects, wherein the inorganic filler contained in the bonding sheet 1 contains boron nitride agglomerated particles.
[11] An eleventh aspect of the present invention is the bonded body according to the tenth aspect, wherein the boron nitride agglomerated particles have a card-house structure.
[12] A twelfth aspect of the present invention is the bonded body according to any one of the first to eleventh aspects, wherein the thermosetting resin contained in the bonding sheet 1 contains epoxy resin.
[13] A thirteenth aspect of the present invention is the bonded body according to any one of the first to twelfth aspects, wherein the bonding sheet 1 has a thickness of 80 µm or more and 300 µm or less.
[14] A fourteenth aspect of the present invention is a bonding sheet being a cured product of a thermosetting resin composition containing a thermosetting resin and an inorganic filler, wherein
   when the bonding sheet 1 is viewed in cross-section, at least one of the following conditions is satisfied:
   a value of P_{1A}/P_{1B} is more than 1.10, where P_{1A} is a resin area ratio in an end region 1A extending 300 µm inward from either the left or right end of the bonding sheet 1, and P_{1B} is a resin area ratio in a central region 1B other than the end region 1A;
   a value of S_{1A}/S_{1B} is more than 1, where S_{1A} is a void area ratio in an end region 1A extending 300 µm inward from either the left or right end of the bonding sheet 1, and S_{1B} is a void area ratio in a central region 1B other than the end region 1A; and
   a value of L_{1A}/L_{1B} is more than 2, where L_{1A} is a void average size in an end region 1A extending 300 µm inward from either the left or right end of the bonding sheet 1, and L_{1B} is a void average size in a central region 1B other than the end region 1A.
[15] A fifteenth aspect of the present invention is a method for producing the bonded body according to any one of the first to thirteenth aspects, including: laminating a thermosetting sheet formed by molding the thermosetting resin composition into a sheet on the lower metal-containing member 3; applying a uniform pressure thereon to bond the lower metal-containing member 3 and the thermosetting sheet together; subsequently laminating the upper metal-containing member 2 on the thermosetting sheet; and applying a uniform pressure thereon to bond the thermosetting sheet and the upper metal-containing member 2 together.
[16] A sixteenth aspect of the present invention is the method for producing the bonded body according to the fifteenth aspect, further including: subjecting the thermosetting sheet to low-temperature aging in an environment of -50°C or higher and 0°C or lower before being laminated on the lower metal-containing member 3.

### EFFECT OF THE INVENTION

The bonded body proposed by the present invention relates to a bonded body including an upper metal-containing member 2 and a lower metal-containing member 3 bonded, respectively, to upper and lower surfaces of a bonding sheet 1, and is capable of suppressing cracks and deformations in the bonding sheet 1 even if stress is applied to the bonding sheet 1 due to a difference in expansion coefficients between the members caused by temperature changes when either one of the following conditions is satisfied: a value of P_{1A}/P_{1B} is more than 1.10, where P_{1A} is a resin area ratio in an end region 1A extending 300 µm inward from either the left or right end of the bonding sheet 1, and P_{1B} is a resin area ratio in a central region 1B other than the end region 1A; a value of S_{1A}/S_{1B} is more than 1, where S_{1A} is a void area ratio in the end region 1A, and S_{1B} is a void area ratio in the central region 1B other than the end region 1A; or a value of L_{1A}/L_{1B} is more than 2, where L_{1A} is a void average size in the end region 1A, and L_{1B} is a void average size in the central region 1B other than the end region 1A.

### BRIEF DESCRIPTION OF DRAWINGS

FIG. 1 is a cross-sectional view of an exemplary bonded body of the present invention, as viewed in cross-section (in the thickness direction).
FIG. 2 is a cross-sectional view of another exemplary bonded body of the present invention, as viewed in cross-section (in the thickness direction).
FIG. 3 is a cross-sectional view of another exemplary bonded body of the present invention, as viewed in cross-section (in the thickness direction).
FIG. 4 is a cross-sectional view of another exemplary bonded body of the present invention, as viewed in cross-section (in the thickness direction).
FIG. 5 is a cross-sectional view of still another exemplary bonded body of the present invention, as viewed in cross-section (in the thickness direction).
FIG. 6 is a partially enlarged cross-sectional view of the still another exemplary bonded body of the present invention.

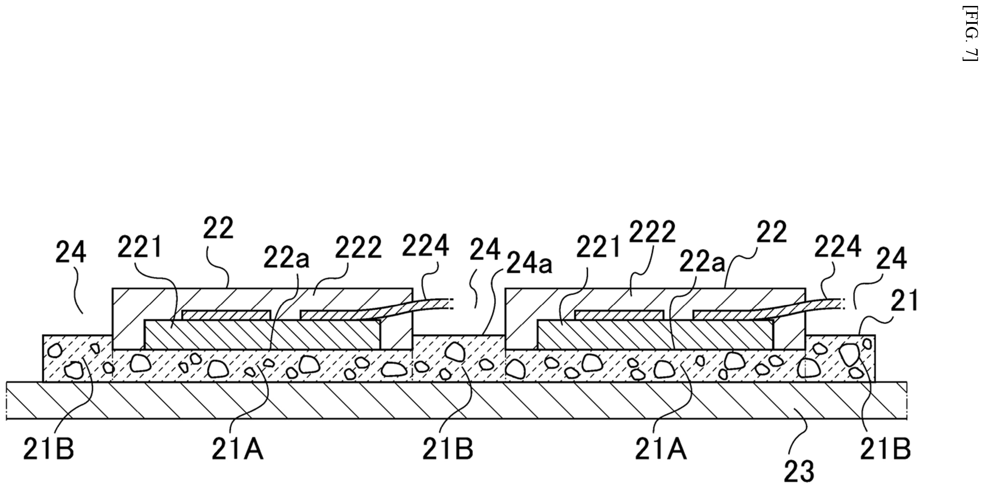

FIG. 7 is a cross-sectional view of still another exemplary bonded body of the present invention, as viewed in cross-section (in the thickness direction).
FIG. 8 is a cross-sectional view of a conventional example of a bonded body in a further example of the present invention, as viewed in cross-section (in the thickness direction).

### MODE(S) FOR CARRYING OUT THE INVENTION

An exemplary embodiment of the present invention will be described below. The present invention, however, is not limited to the embodiment described below.

### <<Present Bonded Body I>>

A bonded body according to one embodiment of the present invention (also referred to as "the present bonded body I") is a bonded body including an upper metal-containing member 2 and a lower metal-containing member 3 bonded, respectively, to the upper and lower surfaces of a bonding sheet 1, as shown in FIG. 1. Specifically, it is a bonded body including an upper metal-containing member 2 bonded to the upper surface of a bonding sheet 1 and a lower metal-containing member 3 bonded to the lower surface of the bonding sheet 1.

In this regard, it is preferable that the bonding sheet 1 is directly bonded to the upper metal-containing member 2, and the bonding sheet 1 is directly bonded to the lower metal-containing member 3. As used herein, the term "directly bonded" means being bonded without any other members in between, and without the use of adhesives (including solder). However, the term "directly bonded" is considered to include cases where the bonding surfaces of the bonding sheet 1 with the upper metal-containing member 2 and the lower metal-containing member 3 are subjected to a thin-layer surface treatment, such as plating including nickel plating or tin plating, chemical treatment, or physical treatment, which will be described later.

As shown in FIG. 1, the present bonded body I, when viewed in cross-section in the thickness direction, may have one entire surface of the bonding sheet 1, i.e., the entire upper surface, bonded to the upper metal-containing member 2, and the other entire surface of the bonding sheet 1, i.e., the entire lower surface, bonded to the lower metal-containing member 3. Consequently, the area of the upper surface of the bonding sheet 1 needs to be equal to or smaller than the area of the lower surface of the upper metal-containing member 2, and the area of the lower surface of the bonding sheet 1 needs to be equal to or smaller than the area of the upper surface of the lower metal-containing member 3.

In this regard, the area of the upper surface of the bonding sheet 1 is preferably 80% or more and 100% or less relative to 100% of the area of the lower surface of the upper metal-containing member 2, and more preferably 90% or more and 100% or less.

In addition, it is preferable that the upper surface of the lower metal-containing member 3 is larger than the lower surface of the upper metal-containing member 2.

With this configuration, one or more upper metal-containing members 2 can be arranged on the lower metal-containing member 3 via a plurality of bonding sheets 1.

The bonding surfaces of the bonding sheet 1, the upper metal-containing member 2, and the lower metal-containing member 3 may be flat surfaces as shown in FIG. 1. However, each of the bonding surfaces may have a recess or a protrusion.

### (Resin Area Ratio)

It is preferable that, when the bonding sheet 1 is viewed in cross-section, the bonding sheet 1 has a value of P_{1A}/P_{1B} being more than 1.10, where P_{1A} is a resin area ratio in an end region 1A extending 300 µm inward from either the left or right end of the bonding sheet 1, and P_{1B} is a resin area ratio in a central region 1B other than the end region 1A.

In the present invention, the term "cross-section" in the "when the bonding sheet 1 is viewed in cross-section" refers to a cross section showing the inner positions and areas from either the left or right end of the bonding sheet 1, and indicates a cross-section cut in the thickness direction along the length or width direction of the bonding sheet 1.

Increasing the resin area ratio P_{1A}, i.e., the resin ratio in the end region 1A relative to the resin area ratio P_{1B} in the central region 1B, preferably increasing the ratio of the two (P_{1A}/P_{1B}) more than 1.10, can suppress cracks and deformations in the bonding sheet 1 even when stress is applied to the bonding sheet 1 due to a difference in expansion coefficients between the members caused by temperature changes.

From such a viewpoint, the value of P_{1A}/P_{1B} is preferably more than 1.10, more preferably 1.11 or more, even more preferably 1.12 or more, and still more preferably 1.13 or more, where P_{1A} is the resin area ratio in the end region 1A extending 300 µm inward from either the left or right end of the bonding sheet 1, and P_{1B} is the resin area ratio in the central region 1B other than the end region 1A. On the other hand, from the viewpoint of suppressing the ingress of atmospheric moisture between the upper metal-containing member 2 and the lower metal-containing member 3, the value of P_{1A}/P_{1B} is more preferably 2.0 or less, even more preferably 1.8 or less, may be 1.5 or less, and may be 1.2 or less.

In the present invention, the region extending 300 µm inward from either the left or right end of the bonding sheet 1 is defined as the end region 1A because this is considered to be the necessary range as a stress relief portion for exhibiting the effects of the present invention, such as improving the reliability of cycle tests, and is also considered to be the minimum range from the viewpoint of maintaining insulation. For example, when the thickness of the bonding sheet 1 is 80 to 300 µm, the range where stress is applied can be estimated to be approximately 100 to 500 µm from either the left or right end of the bonding sheet 1. Accordingly, the present invention defines the region extending 300 µm inward from the end, which is the center of the range of 100 to 500 µm, as the region where the influence of stress can be determined.

To adjust the resin area ratio, i.e., the resin ratio, in the end region 1A and the central region 1B of the bonding sheet 1 as described above, using a method in which an upper metal-containing member 2 and a lower metal-containing member 3 are laminated, respectively, on the upper and lower surfaces of a present thermosetting sheet Ia described below, the bonding sheet 1 is pressed, and the present thermosetting sheet Ia is heated and cured, adjustments may be made to the area ratio of the present thermosetting sheet Ia and the upper metal-containing member 2, the pressing conditions, the type of thermosetting resin, the type of inorganic filler, and the presence or absence and conditions of low-temperature aging. The present invention, however, is not limited to such methods.

The resin area ratios P_{1A} and P_{1B} can be calculated by determining the total area of resins present, i.e., the total resin area, per unit cross-sectional area of the bonding sheet 1, based on a cross-sectional photograph of each region of the bonding sheet 1 and using image analysis software.

### (Void Area Ratio)

It is preferable that, when the bonding sheet 1 is viewed in cross-section, the bonding sheet 1 has a value of S_{1A}/S_{1B} being more than 1, where S_{1A} is a void area ratio in an end region 1A extending 300 µm inward from either the left or right end of the bonding sheet 1, and S_{1B} is a void area ratio in a central region 1B other than the end region 1A.

Increasing the void area ratio S_{1A} in the end region 1A relative to the void area ratio S_{1B} in the central region 1B can suppress cracks and deformations in the bonding sheet 1 even when stress is applied to the bonding sheet 1 due to a difference in expansion coefficients between the members caused by temperature changes.

From such a viewpoint, when the bonding sheet 1 is viewed in cross-section, the value of S_{1A}/S_{1B} is preferably more than 1, more preferably 2 or more, even more preferably 3 or more, still more preferably 4 or more, still more preferably 5 or more, and still more preferably 6 or more, where S_{1A} is the void area ratio in the end region 1A extending 300 µm inward from either the left or right end of the bonding sheet 1, and S_{1B} is the void area ratio in the central region 1B other than the end region 1A. On the other hand, from the viewpoint of suppressing the ingress of atmospheric moisture between the upper metal-containing member 2 and the lower metal-containing member 3, the value of S_{1A}/S_{1B} is more preferably 10 or less, even more preferably 9 or less, may be 8 or less, and may be 7 or less.

It is preferable that the area of the metal portion exposed on the lower surface of the upper metal-containing member 2 is smaller than the area of the bonding sheet 1, and is preferably 20% to 90% of the area of the bonding sheet 1, and more preferably 30% or more or 80% or less.

Furthermore, the area of the metal portion exposed on the lower surface of the upper metal-containing member 2 is preferably 20% to 90% of the central region 1B of the bonding sheet 1, and more preferably 30% or more or 80% or less.

Furthermore, it is preferable that the entire surface of the metal portion exposed on the lower surface of the upper metal-containing member 2 be in contact with the central region 1B of the bonding sheet 1. With such a configuration, discharge from the end surface of the bonding sheet 1 can be suppressed.

To adjust the void area ratio, i.e., the void ratio, in the end region 1A and the central region 1B of the bonding sheet 1 as described above, using a method in which an upper metal-containing member 2 and a lower metal-containing member 3 are laminated, respectively, on the upper and lower surfaces of a present thermosetting sheet Ia described below, the bonding sheet 1 is pressed, and the present thermosetting sheet Ia is heated and cured, adjustments may be made to the area ratio of the present thermosetting sheet Ia and the upper metal-containing member 2, the pressing conditions, the type of thermosetting resin, the type of inorganic filler, and the presence or absence and conditions of low-temperature aging. The present invention, however, is not limited to such methods.

The void area ratios S_{1A} and S_{1B} can be calculated by determining the total area of voids present, i.e., the total void area, per unit cross-sectional area of the bonding sheet 1, based on a cross-sectional photograph of each region of the bonding sheet 1 and using image analysis software.

### (Void Average Size)

It is preferable that, when the bonding sheet 1 is viewed in cross-section, the bonding sheet 1 has a value of L_{1A}/L_{1B} being more than 2, where L_{1A} is a void average size in an end region 1A extending 300 µm inward from either the left or right end of the bonding sheet 1, and L_{1B} is a void average size in a central region 1B other than the end region 1A.

Increasing the void average size L_{1A} in the end region 1A relative to the void average size L_{1B} in the central region 1B, preferably increasing the ratio of the two (L_{1A}/L_{1B}) more than 2, can suppress cracks and deformations in the bonding sheet 1 even when stress is applied to the bonding sheet 1 due to a difference in expansion coefficients between the members caused by temperature changes.

From such a viewpoint, when the bonding sheet 1 is viewed in cross-section, the value of L_{1A}/L_{1B} is preferably more than 2, more preferably 3 or more, even more preferably 4 or more, still more preferably 5 or more, still more preferably 6 or more, still more preferably 7 or more, and still more preferably 8 or more, where L_{1A} is the void average size in the end region 1A extending 300 µm inward from either the left or right end of the bonding sheet 1, and L_{1B} is the void average size in the central region 1B other than the end region 1A. On the other hand, from the viewpoint of suppressing the ingress of atmospheric moisture between the upper metal-containing member 2 and the lower metal-containing member 3, the value of L_{1A}/L_{1B} is more preferably 20 or less, even more preferably 10 or less, and may be 9 or less.

To adjust the void average size in the end region 1A and the central region 1B of the bonding sheet 1 as described above, using a method in which an upper metal-containing member 2 and a lower metal-containing member 3 are laminated, respectively, on the upper and lower surfaces of a present thermosetting sheet Ia described below, the bonding sheet 1 is pressed, and the present thermosetting sheet Ia is heated and cured, adjustments may be made to the area ratio of the present thermosetting sheet Ia and the upper metal-containing member 2, the pressing conditions, the type of thermosetting resin, the type of inorganic filler, and the presence or absence and conditions of low-temperature aging. The present invention, however, is not limited to such methods.

The void average sizes L_{1A} and L_{1B} can be calculated by determining the average area of voids per unit number, based on a cross-sectional photograph of each region of the bonding sheet 1 and using image analysis software.

In the present bonded body I, it is more preferable that the value of P_{1A}/P_{1B} is more than 1.10 and the value of S_{1A}/S_{1B} is more than 1.

It is more preferable that the value of P_{1A}/P_{1B} is more than 1.10 and the value of L_{1A}/L_{1B} is more than 2.

It is more preferable that the value of S_{1A}/S_{1B} is more than 1 and the value of L_{1A}/L_{1B} is more than 2.

It is even more preferable that the value of P_{1A}/P_{1B} is more than 1.10, the value of S_{1A}/S_{1B} is more than 1, and the value of L_{1A}/L_{1B} is more than 2.

However, considering the respective mechanisms of action, it is believed that the present invention achieves the object of suppressing cracks and deformations in the bonding sheet 1 by satisfying at least one of the conditions related to the resin area ratio, void area ratio, and void average size, as will be described later.

It is preferable that the area of the metal portion on the lower surface of the upper metal-containing member 2 is smaller than the area of the bonding sheet 1, and is preferably 20% to 90% of the area of the bonding sheet 1, and more preferably 30% or more or 80% or less.

Furthermore, the area of the metal portion on the lower surface of the upper metal-containing member 2 is preferably 20% to 90% of the central region 1B of the bonding sheet 1, and more preferably 30% or more or 80% or less.

Furthermore, it is preferable that the entire surface of the metal portion on the lower surface of the upper metal-containing member 2 be in contact with the central region 1B. With such a configuration, discharge from the end surface of the bonding sheet 1 can be suppressed.

### (Thermal Conductivity)

In the case where the present bonded body I is used for applications such as power semiconductor devices, industrial equipment, in-vehicle equipment, and power generation energy, the bonding sheet 1 used in the present bonded body I, where both the upper metal-containing member 2 and the lower metal-containing member 3 are bonded, preferably has a thermal conductivity in the thickness direction of 10 W/m·K or more, more preferably 11 W/m·K or more, and even more preferably 12 W/m·K or more. On the other hand, it is preferably 25 W/m·K or less, and more preferably 20 W/m·K or less.

To adjust the thermal conductivity of the bonding sheet 1 as described above, using a method in which an upper metal-containing member 2 and a lower metal-containing member 3 are laminated, respectively, on the upper and lower surfaces of a present thermosetting sheet Ia described below, the bonding sheet 1 is pressed, and the present thermosetting sheet Ia is heated and cured, adjustments may be made to the pressing conditions, the type of thermosetting resin, the type of inorganic filler, and the presence or absence and conditions of low-temperature aging. The present invention, however, is not limited to such methods.

The thermal conductivity in the thickness direction of the bonding sheet 1 can be measured by the following method. For example, the thermal conductivity can be determined by measuring thermal resistance values using a thermal resistance measuring device, and calculating from the slope of a graph plotting the thermal resistance values against the thicknesses.

### (Dielectric Breakdown Voltage (BDV))

In the case where the present bonded body I is used for applications such as power semiconductor devices, industrial equipment, in-vehicle equipment, and power generation energy, the bonding sheet 1 used in the present bonded body I, where both the upper metal-containing member 2 and the lower metal-containing member 3 are bonded, preferably has a dielectric breakdown voltage of 5 kV or more, more preferably 5.5 kV or more, and even more preferably 6 kV or more. A higher dielectric breakdown voltage is more preferable, and there is no particular upper limit.

To adjust the dielectric breakdown voltage of the bonding sheet 1 within the above range, using a method in which an upper metal-containing member 2 and a lower metal-containing member 3 are laminated, respectively, on the upper and lower surfaces of a present thermosetting sheet Ia described below, the bonding sheet 1 is pressed, and the present thermosetting sheet Ia is heated and cured, adjustments may be made to the pressing conditions, the type of thermosetting resin, the type of inorganic filler, and the presence or absence and conditions of low-temperature aging. The present invention, however, is not limited to such methods.

The dielectric breakdown voltage of the bonding sheet 1 can be measured by applying a voltage in the thickness direction of the bonded body.

### <Upper Metal-Containing Member and Lower Metal-Containing Member>

The upper metal-containing member 2 and the lower metal-containing member 3 may each have a metal portion in a bonding surface with the bonding sheet 1. For example, the upper metal-containing member 2 and the lower metal-containing member 3 may themselves be composed of a metal plate or a metal sheet as the metal portion, or may have a configuration in which a metal body serving as the metal portion is exposed on the respective lower or upper surface, and the metal body is covered with an arbitrary material such as a synthetic resin. Alternatively, they may have other configurations.

The shapes and sizes of the upper metal-containing member 2 and the lower metal-containing member 3 are not particularly limited.

### <Upper Metal-Containing Member 2>

As an example of the upper metal-containing member 2, as shown in FIG. 1, a configuration can be cited in which a lower surface of a sheet or plate-shaped metal portion 25 is exposed in the bonding surface with the bonding sheet 1, and the metal portion 25 is covered and sealed with a resin 26.

The metal portion 25 may be in the form of plate, sheet, or any other shape.

The metal portion 25 is preferably composed of a material having good thermal conductivity. In particular, a material containing, for example, copper or aluminum is preferable from the viewpoints of having good thermal conductivity and being relatively inexpensive. From the viewpoint of heat dissipation, it is more preferable that the metal portion 25 is composed of copper.

The bonding surface of the metal portion 25 with the bonding sheet 1, as well as other surfaces, may be subjected to a thin-layer surface treatment, such as plating including nickel plating or tin plating, chemical treatment, or physical roughening treatment.

As the resin 26 for sealing the metal portion 25, for example, a resin having insulating properties can be cited.

Examples of the resin having insulating properties include epoxy resin, vinyl chloride resin, acrylic resin, polypropylene, polyethylene, nylon, polycarbonate, phenol resin, polyarylate, benzoxazine, and isocyanate.

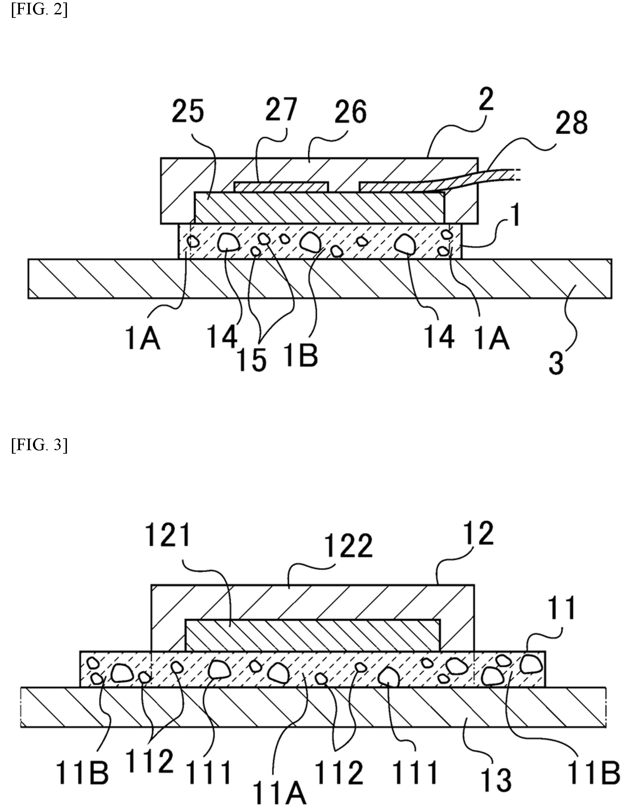

As another example of the upper metal-containing member 2, as shown in FIG. 2, a module configuration can be cited in which a semiconductor chip 27 is mounted on a metal portion 25 serving as a heat-dissipating member, a wiring member 28 is wired on the metal portion 25, and the metal portion 25 and the semiconductor chip 27 are covered and sealed with a resin 26 having insulating properties.

As a more specific example of the upper metal-containing member 2, a module having a molded sealing structure can be cited. As an example of the upper metal-containing member 2, a module can be cited in which each side has a dimension larger than 10 mm and smaller than 150 mm. For example, a module configuration can be cited in which one or more semiconductor chips 27 are mounted on a metal portion 25, a wiring member 28 is wired on the metal portion 25, and the metal portion 25 and the semiconductor chips 27 are embedded in a resin 26, such as epoxy resin, by molding such as transfer molding or compression molding. Examples thereof include power modules such as TO package modules manufactured by Infineon, HybridPACK^{™} DSC manufactured by Infineon, and AIKQ120N75CP2XKSAI manufactured by Infineon. The present invention, however, is not limited to these.

### <Lower Metal-Containing Member 3>

As an example of the lower metal-containing member 3, a member having a planar or sheet-shaped metal body in the bonding surface with the bonding sheet 1 can be cited.

As the planar or sheet-shaped metal body, a material containing, for example, copper or aluminum can be cited. More specifically, a metal plate containing, for example, copper or aluminum can be cited.

As an example of the lower metal-containing member 3, a member having a metal plate with a thickness of 1 mm or more can be cited.

The metal plate may have a protruding and recessed structure in the bonding surface with the bonding sheet 1, on the opposite surface thereof, or on both surfaces thereof. The protruding and recessed structure may be a pin structure or a plate-shaped structure. Alternatively, the metal plate may have a warp.

The metal plate may also have its bonding surface with the bonding sheet 1, the opposite surface thereof, or both surfaces thereof subjected to a surface treatment, such as plating including nickel plating or tin plating, chemical treatment, or physical roughening treatment.

The metal plate may be, for example, a commonly referred to cooling base plate, a cooling fin represented by a pin fin, or a cooling unit. These may be conventionally known ones. Among these, a pin fin is preferable.

### <Bonding Sheet 1>

The bonding sheet 1 contains a thermosetting resin and an inorganic filler 14, and has voids 15 inside.

The bonding sheet 1 is a cured product of a thermosetting resin composition (referred to as "the present thermosetting resin composition Ib") containing a thermosetting resin and an inorganic filler. Specifically, the bonding sheet 1 is a cured product of a thermosetting sheet (referred to as "the present thermosetting sheet Ia") formed by molding the present thermosetting resin composition Ib into a sheet.

In the present invention, the term "thermosetting resin composition" refers to a resin composition having a property of being cured by heat. In other words, it may be a resin composition having curability with room to be cured by heat, a resin composition already cured to a state leaving room for further curing (also referred to as "pre-cured"), or a resin composition not cured at all yet (referred to as "uncured").

The term "thermosetting sheet" refers to a sheet having a property of being cured by heat. In other words, it may be a sheet having curability with room to be cured by heat, a sheet already cured to a state leaving room for further curing (also referred to as "pre-cured"), or a sheet not cured at all yet (referred to as "uncured").

### (Thickness)

The thickness of the bonding sheet 1 is not particularly limited.

In the case where the present bonded body I is used for applications such as power semiconductor devices, industrial equipment, in-vehicle equipment, and power generation energy, the thickness of the bonding sheet 1 is preferably 80 µm or more, more preferably 100 µm or more, even more preferably 110 µm or more, and still more preferably 120 µm or more. On the other hand, the upper limit of the thickness is preferably 300 µm or less, more preferably 250 µm or less, even more preferably 220 µm or less, still more preferably 200 µm or less, and still more preferably 180 µm or less.

By setting the thickness of the bonding sheet 1 to 80 µm or more, it is possible to not only ensure high heat dissipation but also ensure sufficient withstand voltage characteristics. On the other hand, by setting the thickness thereof to 300 µm or less, it is possible to achieve a reduction in size or thickness of the present bonded body I and to reduce thermal resistance in the thickness direction through the thinning, compared to an insulating thermally conductive layer made of a ceramic material.

The thickness of the bonding sheet 1 is reduced by thermal pressing during the production of the present bonded body I. In that case, the rate of thickness reduction is preferably 1% or more, and more preferably 2% or more, from the viewpoint of insulating properties. On the other hand, from the viewpoint of shape retention, it is preferably 10% or less, and more preferably 8% or less.

### (Present Thermosetting Resin Composition Ib)

The present thermosetting resin composition Ib is not particularly limited, provided that it contains a thermosetting resin and an inorganic filler and the bonding sheet 1 satisfies the above-mentioned physical properties.

As the thermosetting resin, a conventionally known resin may be used, and examples thereof include epoxy resin, phenol resin, urea resin, melamine resin, polyester (unsaturated polyester) resin, polyimide resin, silicone resin, polyurethane resin, maleimide resin, cyanate resin, and benzoxazine. In particular, it is preferable that the thermosetting resin contains epoxy resin. The thermosetting resin may be used alone or in a mixture of two or more of these resins.

As the inorganic filler, a conventionally known inorganic filler may be used, and examples thereof include particles of nitrides such as boron nitride, and metal oxides such as alumina. The inorganic filler may be used alone or in a mixture of two or more of these inorganic fillers.

In particular, it is preferable that the inorganic filler contains boron nitride agglomerated particles, i.e., boron nitride agglomerated particles formed by agglomerating primary particles of boron nitride, from the viewpoints of having low moisture absorption and low toxicity during thermal molding, efficiently increasing thermal conductivity, and imparting high insulating properties to the bonding sheet 1.

The agglomerated structure of the boron nitride agglomerated particles is preferably a card-house structure from the viewpoint of improving thermal conductivity. In other words, it is preferable that the boron nitride agglomerated particles have a card-house structure.

The card-house structure is a structure in which plate-shaped particles are complicatedly laminated without being oriented, and is described in "Ceramics 43, No. 2" (published by The Ceramic Society of Japan in 2008). More specifically, the card-house structure refers to a structure in which the planar portion of primary particles forming agglomerated particles is in contact with the end face portion of other primary particles present in the agglomerated particles.

The boron nitride agglomerated particles having the card-house structure have extremely high fracture strength due to their structure, thereby suppressing crushing even when pressure is applied in the production process of the bonding sheet 1. Accordingly, it is possible to allow the primary particles, which are normally oriented in the longitudinal direction of the sheet, to be present in random directions. Thus, the use of the boron nitride agglomerated particles having the card-house structure increases an orientation ratio of the ab-planes of the primary particles in the thickness direction of the bonding sheet 1, thereby enabling effective heat conduction and further enhancing thermal conductivity in the thickness direction of the bonding sheet 1.

The content of the thermosetting resin is preferably 5% by mass or more and 99% by mass or less relative to 100% by mass of the solid content, which is the total solid content of the present thermosetting resin composition Ib excluding the inorganic filler.

The content of the thermosetting resin is preferably 5% by mass or more for good moldability, and 99% by mass or less for ensuring the content of other components and enhancing thermal conductivity.

From such a viewpoint, the content of the thermosetting resin is preferably 5% by mass or more and 99% by mass or less relative to 100% by mass of the solid content, which is the total solid content of the present thermosetting resin composition Ib excluding the inorganic filler. More preferably, the content is 10% by mass or more, even more preferably 20% by mass or more, still more preferably 30% by mass or more, still more preferably 40% by mass or more, and still more preferably 50% by mass or more. On the other hand, the content is preferably 98% by mass or less.

The total content of the inorganic filler is preferably 40% by mass or more and 90% by mass or less relative to 100% by mass of the total solid content of the present thermosetting resin composition Ib.

The total content of the inorganic filler is preferably 40% by mass or more for enhancing thermal conductivity, and 90% by mass or less for enhancing adhesion and insulating properties.

From such a viewpoint, the total content of the inorganic filler is preferably 40% by mass or more relative to 100% by mass of the total solid content of the present thermosetting resin composition Ib. More preferably, the total content is 50% by mass or more, even more preferably 53% by mass or more, and still more preferably 55% by mass or more. On the other hand, the total content is preferably 90% by mass or less, more preferably 80% by mass or less, even more preferably 75% by mass or less, and still more preferably 72% by mass or less.

As described above, it is preferable that the thermosetting resin contains epoxy resin, and that the inorganic filler contains boron nitride agglomerated particles formed by agglomerating primary particles of boron nitride, from the viewpoints of water resistance and low dielectric constant. In particular, from the viewpoints of high thermal conductivity and high withstand voltage, it is preferable that the inorganic filler contains boron nitride agglomerated particles having a card-house structure, and that the shape is spherical.

In this case, the content ratio of the boron nitride agglomerated particles having a card-house structure is preferably 40% by mass or more and 90% by mass or less relative to 100% by mass of the total solid content of the present thermosetting resin composition Ib. More preferably, the content ratio is 50% by mass or more or 80% by mass or less, and even more preferably 55% by mass or more or 70% by mass or less.

The present thermosetting resin composition Ib may optionally further contain, in addition to the thermosetting resin and the inorganic filler, other polymers, a curing agent, a curing accelerator, an organic solvent, and other components, and these may be conventionally known compositions, such as those described in WO 2023/189030.

### <Method for Producing Present Bonded Body I>

Next, a method for producing the present bonded body I will be described.

A method for producing the present bonded body I includes a method of arranging the present thermosetting sheet Ia (bonding sheet 1) between an upper metal-containing member 2 and a lower metal-containing member 3 and controlling pressing conditions such as press pressure, press temperature, and press configuration; or a method of previously preparing a bonding sheet 1 having regions with different resin area ratios, void area ratios, or void average sizes and arranging the bonding sheet 1 between an upper metal-containing member 2 and a lower metal-containing member 3. The former method of controlling the pressing conditions is preferable.

The method described below is merely an example of a method for producing the present bonded body I, and is not limited to the following method.

An example of the method for producing the present bonded body I may include: laminating the present thermosetting sheet Ia (bonding sheet 1), which is formed by molding the present thermosetting resin composition Ib into a sheet, on a lower metal-containing member 3; applying a uniform pressure thereon to bond the lower metal-containing member 3 and the present thermosetting sheet Ia (bonding sheet 1) together; subsequently laminating an upper metal-containing member 2 on the present thermosetting sheet Ia (bonding sheet 1); and applying a uniform pressure thereon to bond the present thermosetting sheet Ia (bonding sheet 1) and the upper metal-containing member 2 together.

In this regard, it is preferable that the present thermosetting sheet Ia (bonding sheet 1) is subjected to low-temperature aging in an environment of -50°C or higher and 0°C or lower beforehand, specifically before being laminated on the lower metal-containing member 3 as described above.

Note that the term "the present thermosetting sheet Ia (bonding sheet 1)" is used herein because the present thermosetting sheet Ia is also the bonding sheet 1.

The following provides a more detailed explanation.

First, it is preferable to laminate the present thermosetting sheet Ia (bonding sheet 1) on a lower metal-containing member 3 and apply a uniform pressure (first pressing) thereon to bond the lower metal-containing member 3 and the present thermosetting sheet Ia (bonding sheet 1) together.

In this regard, to ensure uniform pressure distribution, a cushioning material made of an arbitrary material, such as copy paper, a fluorine-based film such as Teflon, a silicone rubber sheet, carbon paper, or a graphite sheet, may be used.

Second, it is preferable to laminate an upper metal-containing member 2 on the present thermosetting sheet Ia (bonding sheet 1) and apply a uniform pressure (second pressing) thereon to bond the present thermosetting sheet Ia (bonding sheet 1) and the upper metal-containing member 2 together. That is, the present thermosetting sheet Ia (bonding sheet 1), which overlaps with both the upper metal-containing member 2 and the lower metal-containing member 3 when viewed in cross-section, is pressed, and the entire present thermosetting sheet Ia (bonding sheet 1) is heated for thermosetting and bonding the upper metal-containing member 2 and the lower metal-containing member 3 to the upper and lower surfaces of the bonded body sheet 1 thereby producing the present bonded body I. In this regard, the area of the lower surface of the upper metal-containing member 2 is preferably 80% to 100% of the area of the upper surface of the present thermosetting sheet Ia (bonding sheet 1).

A plurality of upper metal-containing members 2 may be bonded together in a sheet form.

To ensure uniform pressure distribution, a cushioning material made of an arbitrary material, such as copy paper, a fluorine-based film such as Teflon, a silicone rubber sheet, carbon paper, or a graphite sheet, may be used.

For the first pressing, it is sufficient to be able to temporarily fix the present thermosetting sheet Ia (bonding sheet 1) on the lower metal-containing member 3, and it is thus preferable to apply a pressure such that a load of 0.5 MPa or more and 10 MPa or less is applied to the present thermosetting sheet Ia (bonding sheet 1), more preferably a load of 1 MPa or more or 9 MPa or less, and even more preferably a load of 2 MPa or more or 8 MPa or less.

By the second pressing, i.e., by applying a pressure to the present thermosetting sheet Ia (bonding sheet 1), which overlaps with both the upper metal-containing member 2 and the lower metal-containing member 3 when viewed in cross-section, the sheet can flow laterally to increase the resin ratio in the end region 1A, and the voids can flow laterally while being crushed, thereby increasing the size of the voids in the end region 1A and increasing the void ratio.

In addition, by preventing the destruction of the secondary particles of the inorganic filler, such as boron nitride agglomerated particles, good contact between the inorganic fillers can be ensured, thereby facilitating the formation of thermal conduction paths and enhancing thermal conductivity.

Furthermore, by reducing the viscosity of the resin component through high-temperature pressing, the present thermosetting sheet Ia (bonding sheet 1) is allowed to undergo minute end-face flow, thereby relieving stress in the end region 1A where pressure is likely to be locally concentrated during high-pressure pressing.

From such a viewpoint, it is desirable to apply a load of 2 MPa or more in the second pressing.

The load is preferably 4 MPa or more, more preferably 5 MPa or more, and even more preferably 6 MPa or more. On the other hand, the load is preferably 150 MPa or less, more preferably 100 MPa or less, and even more preferably 20 MPa or less.

In the second pressing, heating may also be performed simultaneously.

In this regard, the heating temperature (product temperature) is preferably 10°C or higher, more preferably 20°C or higher, and even more preferably 30°C or higher. The heating temperature is preferably 300°C or lower, more preferably 250°C or lower, and even more preferably 200°C or lower.

By performing the second pressing within the above temperature range, the melt viscosity of the resin in the present thermosetting sheet Ia (bonding sheet 1) can be reduced, thereby facilitating the lateral flow of the sheet and further increasing the resin ratio in the end region 1A. In addition, the voids also easily flow laterally while being crushed, thereby increasing the size of the voids in the end region 1A and increasing the void ratio.

As a specific example, both pressing and heating can be performed simultaneously by: pre-heating upper and lower platens of a press machine; laminating the upper metal-containing member 2 on the present thermosetting sheet Ia (bonding sheet 1), which has been laminated on the lower metal-containing member 3, to form a laminate; setting the laminate in the press machine; and pressing the laminate between the upper and lower platens. Alternatively, both pressing and heating can be performed simultaneously by: laminating the present thermosetting sheet Ia (bonding sheet 1) on the lower metal-containing member 3 and then laminating the upper metal-containing member 2 on the present thermosetting sheet Ia (bonding sheet 1) to form a laminate; setting the laminate in a press machine; and heating the press machine or its pressing portion to apply a pressure. In this regard, both the regions 1A and 1B of the present thermosetting sheet Ia (bonding sheet 1) are heated.

The temperature of the platens can be considered equivalent to the product temperature of the present thermosetting sheet Ia (bonding sheet 1).

The pressing time for the second pressing is not particularly limited. The time is preferably 30 seconds or more, more preferably 1 minute or more, even more preferably 3 minutes or more, and particularly preferably 5 minutes or more. The time for the pressing step is preferably 1 hour or less, more preferably 30 minutes or less, and even more preferably 20 minutes or less.

By setting the pressing time at or below the aforementioned upper limit, it is possible to reduce the production time, which tends to reduce the production cost. By setting the pressing time at or above the aforementioned lower limit, it is possible to lower the void content within the present thermosetting sheet Ia (bonding sheet 1), which tends to improve the heat transfer performance and withstand voltage characteristics.

Alternatively, the present thermosetting sheet Ia (bonding sheet 1) may be heated for curing after the second pressing.

In this regard, the heating temperature (product temperature) is preferably 30°C to 400°C, more preferably 50°C or higher, and even more preferably 90°C or higher. On the other hand, it is preferably 300°C or lower, and more preferably 250°C or lower.

For the aforementioned pressing method, various conventionally known press machines for molding thermosetting resins can be used. From the viewpoint of preventing resin deterioration during heat-pressing, it is particularly preferable to use a vacuum press machine capable of reducing the amount of oxygen in the press machine during heating, or a press machine equipped with a nitrogen substitution apparatus.

As for the heating in the aforementioned method, a method such as controlling the temperature of the upper and lower platens of the press machine may be used.

It is preferable that the present thermosetting sheet Ia is subjected to low-temperature aging beforehand, specifically at least before being laminated on the lower metal-containing member 3.

For the low-temperature aging, for example, the present thermosetting sheet Ia may be exposed in an environment of preferably -50°C or higher and 0°C or lower, more preferably - 30°C or higher or -5°C or lower, for a period of preferably 5 minutes or more and 365 days or less, more preferably 1 hour or more or 7 days or less.

No pressure is required during the low-temperature aging. However, a minute pressure of 0.1 kPa or less may be applied.

The timing for the low-temperature aging may be, for example, after coating, after heating and drying, or after pressing. Among these timings, after pressing is preferable. Note that the pressing in this regard refers not to the heat-pressing performed when producing the present bonded body I, but rather to the pressing performed beforehand when producing the present thermosetting sheet Ia.

By subjecting the present thermosetting sheet Ia to such low-temperature aging, the moisture inside the sheet can be frozen and dispersed as minute ice, and even after returning to room temperature, small chambers for the moisture that remains trapped in tiny spaces can be formed, which can suppress the occurrence of cracks when the sheet is bent due to moisture retention, while preventing the deterioration of insulating properties without generating large voids. Furthermore, minute voids are highly dispersed in the sheet, and thus the fluidity of the resin component can be increased during pressing, which increases the resin ratio at the end. Simultaneously, voids inside the sheet tend to be pushed out toward the end, and the voids accumulated in the end are expected to connect and increase in size. It is also expected to provide a stress relaxation effect at the interface end of the present bonded body I.

### <<Present Bonded Body II>>

A bonded body according to another embodiment of the present invention (also referred to as "the present bonded body II") is a bonded body including an upper metal-containing member 12 and a lower metal-containing member 13 bonded, respectively, to the upper and lower surfaces of a bonding sheet 11, as shown in FIG. 3, wherein
the upper metal-containing member 12 and the lower metal-containing member 13 each have a metal portion in a bonding surface with the bonding sheet 11;
the bonding sheet 11 contains a thermosetting resin and an inorganic filler, and has voids therein;
when the bonded body is viewed in cross-section (thickness direction), the bonding sheet 11 has a region 11A overlapping with both the upper metal-containing member 12 and the lower metal-containing member 13, and a region 11B overlapping with only the lower metal-containing member 13; and
the bonding sheet 11 has an area ratio of voids present in the region 11B (void ratio X_{B}) that is larger than an area ratio of voids present in the region 11A (void ratio X_{A}).

The present bonded body II may also be a bonded body including an upper metal-containing member 12 and a lower metal-containing member 13 bonded, respectively, to the upper and lower surfaces of a bonding sheet 11, wherein
the upper metal-containing member 12 and the lower metal-containing member 13 each have a metal portion in a bonding surface with the bonding sheet 11;
the bonding sheet 11 contains a thermosetting resin and an inorganic filler, and has voids therein;
when the bonded body is viewed in cross-section (thickness direction), the bonding sheet 11 has a region 11A overlapping with both the upper metal-containing member 12 and the lower metal-containing member 13, and a region 11B overlapping with only the lower metal-containing member 13; and
the bonding sheet 11 has a storage elastic modulus Y_{B} at 200°C in the region 11B that is smaller than a storage elastic modulus Y_{A} at 200°C in the region 11A.

In a bonded body including an upper metal-containing member 12 and a lower metal-containing member 13 bonded, respectively, to the upper and lower surfaces of a bonding sheet 11 (corresponding to the insulating substrate) as shown in FIG. 3, when used for applications such as the power semiconductor devices described above, it has been found that when stress is applied to the bonding sheet 11 due to a difference in expansion coefficients between the members caused by temperature changes, pressure is concentrated locally in the peripheral region 11B, instead of the region 11A where the bonding sheet 11 overlaps with both the upper metal-containing member 12 and the lower metal-containing member 13 when viewed in cross-section (thickness direction), which causes cracks and deformations occurring in the peripheral region 11B. It has also been found that, in the production of the bonded body, when the upper metal-containing member 12 and the lower metal-containing member 13 are pressed against the bonding sheet 11 with a high pressure, pressure is concentrated locally in the peripheral region 11B, instead of the region 11A where the bonding sheet 11 overlaps with both the upper metal-containing member 12 and the lower metal-containing member 13 when viewed in cross-section (thickness direction) as shown in FIG. 3, which causes cracks and deformations occurring in the peripheral region 11B.

Therefore, an object of the present bonded body II is to provide a novel bonded body and a method for producing the bonded body, wherein the bonded body, which includes an upper metal-containing member 12 and a lower metal-containing member 13 bonded, respectively, to the upper and lower surfaces of a bonding sheet 11, can eliminate cracks and deformations in the peripheral region 11B of the bonding sheet 11, which surrounds the region 11A where the bonding sheet 11 overlaps with both the upper metal-containing member 12 and the lower metal-containing member 13.

In the present bonded body II including an upper metal-containing member 12 and a lower metal-containing member 13 bonded, respectively, to the upper and lower surfaces of a bonding sheet 11, by increasing the area ratio of voids (void ratio X_{B}) present in the peripheral region 11B of the bonding sheet 11 compared to the area ratio of voids (void ratio X_{A}) present in the region 11A where the bonding sheet 11 overlaps with both the upper metal-containing member 12 and the lower metal-containing member 13 when viewed in cross-section (thickness direction), or by reducing the storage elastic modulus Y_{B} at 200°C in the peripheral region 11B compared to the storage elastic modulus Y_{A} at 200°C in the region 11A, cracks and deformations in the region 11B can be eliminated during and after the production of the bonded body.

The present bonded body II is a bonded body including an upper metal-containing member 12 and a lower metal-containing member 13 bonded, respectively, to the upper and lower surfaces of a bonding sheet 11, as shown in FIG. 3. Specifically, it is a bonded body including an upper metal-containing member 12 bonded to one side of a bonding sheet 11 and a lower metal-containing member 13 bonded to the other side of the bonding sheet 11.

In this regard, it is preferable that the bonding sheet 11 is directly bonded to the upper metal-containing member 12, and the bonding sheet 11 is directly bonded to the lower metal-containing member 13. As used herein, the term "directly bonded" means being bonded without any other members in between, and without the use of adhesives (including solder). However, the term "directly bonded" is considered to include cases where the bonding surfaces of the bonding sheet 11 with the upper metal-containing member 12 and the lower metal-containing member 13 are subjected to a thin-layer surface treatment, such as plating including nickel plating or tin plating, chemical treatment, or physical treatment, which will be described later.

In the present bonded body II, as shown in FIG. 3, when the bonded body is viewed in cross-section (thickness direction), the bonding sheet 11 has a region 11A overlapping with both the upper metal-containing member 12 and the lower metal-containing member 13, and a region 11B overlapping with only the lower metal-containing member 13.

The region 11A of the bonding sheet 11 can also be referred to as a region sandwiched between both the upper metal-containing member 12 and the lower metal-containing member 13. On the other hand, the region 11B is a peripheral region surrounding the region 11A, wherein its lower surface is bonded to the lower metal-containing member 13, and its upper surface is not bonded to the upper metal-containing member 12.

The bonding surfaces of the bonding sheet 11, the upper metal-containing member 12, and the lower metal-containing member 13 may be flat surfaces as shown in FIG. 3. However, each of the bonding surfaces may have a recess or a protrusion.

In the present invention, the term "cross-section" in the "when the bonded body is viewed in cross-section (thickness direction)" refers to a cross-section cut in the thickness direction along the length or width direction of the bonding sheet 11.

### (Void Ratio)

The bonding sheet 11 contains a thermosetting resin and an inorganic filler 111 and has voids 112 therein, and it is preferable that the bonding sheet 11 has an area ratio of voids 112 present in the region 11B (void ratio X_{B}) that is larger than an area ratio of voids 112 present in the region 11A (void ratio X_{A}).

When the bonded body includes an upper metal-containing member 12 and a lower metal-containing member 13 bonded, respectively, to the upper and lower surfaces of a bonding sheet 11, cracks and deformations may occur in the peripheral region of the bonding sheet 11, which surrounds the region 11A where the bonding sheet 11 is sandwiched between both the upper metal-containing member 12 and the lower metal-containing member 13, i.e., in the region 11B, as described above. However, it has been found that increasing the area ratio of voids present in the region 11B (void ratio X_{B}) compared to the area ratio of voids present in the region 11A (void ratio X_{A}) can suppress cracks and deformations occurring in the region 11B during and after the production of the bonded body.

From such a viewpoint, the ratio (X_{B}/X_{A}) of the area ratio of voids present in the region 11B of the bonding sheet 11 (void ratio X_{B}) to the area ratio of voids present in the region 11A (void ratio X_{A}) is preferably more than 2.0, more preferably 5.0 or more, even more preferably 10 or more, still more preferably 20 or more, still more preferably 50 or more, still more preferably 100 or more, and still more preferably 200 or more. On the other hand, from the viewpoint of suppressing the ingress of atmospheric moisture between the upper metal-containing member 12 and the lower metal-containing member 13, the ratio (X_{B}/X_{A}) is more preferably 400 or less, and even more preferably 300 or less.

The area ratio of voids present in the region 11A of the bonding sheet 11 (void ratio X_{A}) is preferably 0% or more and 0.4% or less from the viewpoint of withstand voltage. More preferably, it is 0% or more or 0.2% or less, even more preferably 0% or more or 0.1% or less, and still more preferably 0% or more or 0.05% or less.

On the other hand, the area ratio of voids present in the region 11B of the bonding sheet 11 (void ratio X_{B}) is preferably 0.5% or more and 20% or less from the viewpoint of suppressing cracks and deformations when bonding the members, while maintaining a certain level of withstand voltage. More preferably, it is 1% or more or 15% or less, even more preferably 2% or more or 10% or less, still more preferably 3% or more or 9% or less, and still more preferably 5% or more or 8% or less.

To adjust the area ratios of voids (void ratios) present in the regions 11A and 11B of the bonding sheet 11 as described above, using a method in which an upper metal-containing member 12 and a lower metal-containing member 13 are laminated, respectively, on the upper and lower surfaces of a present thermosetting sheet IIa described below, the region 11A of the bonding sheet 11 is pressed, and the present thermosetting sheet IIa is heated and cured, adjustments may be made to the pressing conditions, the type of thermosetting resin, the type of inorganic filler, and the presence or absence and conditions of low-temperature aging. The present invention, however, is not limited to such methods.

The void ratios X_{A} and X_{B} can be calculated as an average value of five fields of view, based on a cross-sectional photograph of each region of the bonding sheet 11, by determining the total void area per unit cross-sectional area of voids present in each region of the bonding sheet 11, using image analysis software.

### (Average Void Area)

It is preferable that the bonding sheet 11 has an average void area of the voids 112 present in the region 11A of 10 µm² or less from the viewpoints of ensuring insulating properties and suppressing partial discharge. More preferably, the average void area is 5 µm² or less, even more preferably 2 µm² or less, and still more preferably 1.5 µm² or less. The lower limit of the average void area is not particularly limited, and may be 0 µm² or more.

The average void area of the voids 112 present in the region 11B of the bonding sheet 11 is preferably 20 µm² or more from the viewpoint of stress relaxation. More preferably, it is 50 µm² or more, even more preferably 100 µm² or more, and still more preferably 200 µm² or more. On the other hand, from the viewpoint of suppressing the ingress of atmospheric moisture between the upper metal-containing member 12 and the lower metal-containing member 13, the average void area is preferably 700 µm² or less, more preferably 600 µm² or less, even more preferably 500 µm² or less, and still more preferably 300 µm² or less.

The method for adjusting the average void areas of the voids in the regions 11A and 11B of the bonding sheet 11 is the same as the method for adjusting the void ratios described above.

The average void areas of the voids present in the regions 11A and 11B of the bonding sheet 11 can be calculated as an average value of five fields of view, based on a cross-sectional photograph of each region of the bonding sheet 11, using image analysis software.

### (Storage Elastic Modulus)

It is preferable that the bonding sheet 11 has a storage elastic modulus Y_{B} at 200°C in the region 11B that is smaller than a storage elastic modulus Y_{A} at 200°C in the region 11A.

When the bonded body includes an upper metal-containing member 12 and a lower metal-containing member 13 bonded, respectively, to the upper and lower surfaces of the bonding sheet 11, it has been found that reducing the storage elastic modulus Y_{B} at 200°C in the region 11B of the bonding sheet 11 compared to the storage elastic modulus Y_{A} at 200°C in the region 11A can suppress cracks and deformations in the region 11B during and after the production of the bonded body.

From such a viewpoint, the ratio (Y_{B}/Y_{A}) of the storage elastic modulus Y_{B} at 200°C in the region 11B to the storage elastic modulus Y_{A} at 200°C in the region 11A is preferably 0.8 or less, more preferably 0.79 or less, even more preferably 0.75 or less, and still more preferably 0.73 or less. On the other hand, from the viewpoint of resisting external impacts, the ratio (Y_{B}/Y_{A}) is more preferably 0.1 or more, even more preferably 0.5 or more, and still more preferably 0.6 or more.

The storage elastic modulus Y_{A} at 200°C in the region 11A of the bonding sheet 11 is preferably 1.0 × 10⁹ Pa or more and 1.0 × 10¹¹ Pa or less from the viewpoints of mechanical strength and adhesion strength. More preferably, it is 2.0 × 10⁹ Pa or more or 8.0 × 10¹⁰ Pa or less, even more preferably 3.0 × 10⁹ Pa or more or 2.0 × 10¹⁰ Pa or less, and still more preferably 5.0 × 10⁹ Pa or more or 1.0 × 10¹⁰ Pa or less.

The storage elastic modulus Y_{B} at 200°C in the region 11B of the bonding sheet 11 is preferably 1.0 × 10⁸ Pa or more and 1.0 × 10¹¹ Pa or less from the viewpoint of suppressing cracks and deformations when bonding the members, while relaxing the generated stress. More preferably, it is 5.0 × 10⁸ Pa or more or 5.0 × 10¹⁰ Pa or less, even more preferably 1.0 × 10⁹ Pa or more or 1.0 × 10¹⁰ Pa or less, and still more preferably 3.0 × 10⁹ Pa or more or 1.0 × 10¹⁰ Pa or less.

To adjust the storage elastic moduli at 200°C in the regions 11A and 11B of the bonding sheet 11 as described above, using a method in which an upper metal-containing member 12 and a lower metal-containing member 13 are laminated, respectively, on the upper and lower surfaces of a present thermosetting sheet IIa described below, the region 11A of the bonding sheet 11 is pressed, and the present thermosetting sheet IIa is heated and cured, adjustments may be made to the pressing conditions, the type of thermosetting resin, the type of inorganic filler, and the presence or absence and conditions of low-temperature aging. The present invention, however, is not limited to such methods.

The storage elastic moduli Y_{A} and Y_{B} at 200°C can be measured by separating only the bonding sheet 11 from the bonded body and measuring the storage elastic moduli at 200°C in the regions 11A and 11B. In Example II-1 described below, a bonding sheet is produced with the same composition and under the same pressing and heating conditions as in Example II-1, and the storage elastic moduli at 200°C in the regions 11A and 11B are measured. The same applies to the void ratio and thermal conductivity.

The bonding sheet 11 of the present invention may be such that the area ratio of voids present in the region 11B of the bonding sheet 11 (void ratio X_{B}) is larger than the area ratio of voids present in the region 11A (void ratio X_{A}), or the storage elastic modulus Y_{B} at 200°C in the region 11B of the bonding sheet 11 is smaller than the storage elastic modulus Y_{A} at 200°C in the region 11A; and may preferably be such that the area ratio of voids present in the region 11B of the bonding sheet 11 (void ratio X_{B}) is larger than the area ratio of voids present in the region 11A (void ratio X_{A}), and the storage elastic modulus Y_{B} at 200°C in the region 11B of the bonding sheet 11 is smaller than the storage elastic modulus Y_{A} at 200°C in the region 11A.

### (Thermal Conductivity)

In the case where the present bonded body II is used for applications such as power semiconductor devices, industrial equipment, in-vehicle equipment, and power generation energy, the bonding sheet 11 preferably has a thermal conductivity in the thickness direction in the region 11A of 10 W/m·K or more, more preferably 11 W/m·K or more, and even more preferably 12 W/m·K or more. On the other hand, it is preferably 25 W/m·K or less, and more preferably 20 W/m·K or less.

To adjust the thermal conductivity in the region 11A of the bonding sheet 11 as described above, using a method in which an upper metal-containing member 12 and a lower metal-containing member 13 are laminated, respectively, on the upper and lower surfaces of a present thermosetting sheet IIa described below, the region 11A of the bonding sheet 11 is pressed, and the present thermosetting sheet IIa is heated and cured, adjustments may be made to the pressing conditions, the type of thermosetting resin, the type of inorganic filler, and the presence or absence and conditions of low-temperature aging. The present invention, however, is not limited to such methods.

The thermal conductivity in the thickness direction in the region 11A of the bonding sheet 11 can be measured by the following method. For example, the thermal conductivity can be determined by measuring thermal resistance values using a thermal resistance measuring device, and calculating from the slope of a graph plotting the thermal resistance values against the thicknesses.

### (Dielectric Breakdown Voltage (BDV))

In the case where the present bonded body II is used for applications such as power semiconductor devices, industrial equipment, in-vehicle equipment, and power generation energy, the bonding sheet 11 preferably has a dielectric breakdown voltage in the region 11A of 5 kV or more, more preferably 5.5 kV or more, and even more preferably 6 kV or more. A higher dielectric breakdown voltage is more preferable, and there is no particular upper limit.

To adjust the dielectric breakdown voltage in the region 11A of the bonding sheet 11 as described above, using a method in which an upper metal-containing member 12 and a lower metal-containing member 13 are laminated, respectively, on the upper and lower surfaces of a present thermosetting sheet IIa described below, the region 11A of the bonding sheet 11 is pressed, and the present thermosetting sheet IIa is heated and cured, adjustments may be made to the pressing conditions, the type of thermosetting resin, the type of inorganic filler, and the presence or absence and conditions of low-temperature aging. The present invention, however, is not limited to such methods.

The dielectric breakdown voltage in the region 11A of the bonding sheet 11 can be measured by applying a voltage in the thickness direction of the bonded body.

### <Upper Metal-Containing Member 12 and Lower Metal-Containing Member 13>

Both the upper metal-containing member 12 and the lower metal-containing member 13 are the same as the upper metal-containing member 2 and the lower metal-containing member 3 of the present bonded body I, respectively. That is, the upper metal-containing member 2 of the present bonded body I is read as the upper metal-containing member 12 of the present bonded body II, and the lower metal-containing member 3 of the present bonded body I is read as the lower metal-containing member 13 of the present bonded body II. Similarly, the metal portion 25, resin 26, semiconductor chip 27, and wiring member 28 in the present bonded body I are read as the metal portion 121, resin 122, semiconductor chip 123, and wiring member 124, respectively.

### <Bonding Sheet 11>

The bonding sheet 11 contains a thermosetting resin and an inorganic filler 111, and has voids 112 therein.

The bonding sheet 11 is a cured product of a thermosetting resin composition (referred to as "the present thermosetting resin composition IIb") containing a thermosetting resin and an inorganic filler. Specifically, the bonding sheet 11 is a cured product of a thermosetting sheet (referred to as "the present thermosetting sheet IIa") formed by molding the present thermosetting resin composition IIb into a sheet.

### (Thickness)

The thickness of the bonding sheet 11 is the same as that of the bonding sheet 1 of the present bonded body I.

### (Present Thermosetting Resin Composition IIb)

The composition of the thermosetting resin composition for forming the bonding sheet 11 is the same as that of the thermosetting resin composition for forming the bonding sheet 1. That is, the present thermosetting resin composition IIb is the same as the present thermosetting resin composition Ib in the bonding sheet 1.

### <Method for Producing Present Bonded Body II>

Next, a method for producing the present bonded body II will be described.

A method for producing the present bonded body II includes a method of arranging the present thermosetting sheet IIa (bonding sheet 11) between an upper metal-containing member 12 and a lower metal-containing member 13 and controlling pressing conditions such as press pressure, press temperature, and press configuration; or a method of previously preparing a bonding sheet 11 having regions with different void ratios or storage elastic moduli and arranging the bonding sheet 11 between an upper metal-containing member 12 and a lower metal-containing member 13. The former method of controlling the pressing conditions is preferable.

The method described below is merely an example of a method for producing the present bonded body II, and is not limited to the following method.

An example of the method for producing the present bonded body II may include: laminating the present thermosetting sheet IIa (bonding sheet 11), which is formed by molding the present thermosetting resin composition IIb containing a thermosetting resin and an inorganic filler into a sheet, on a lower metal-containing member 13; applying a uniform pressure thereon to bond the lower metal-containing member 13 and the present thermosetting sheet IIa (bonding sheet 11) together; subsequently laminating an upper metal-containing member 12 on the present thermosetting sheet IIa (bonding sheet 11); and applying a pressure to a region 11A that overlaps with both the upper metal-containing member 12 and the lower metal-containing member 13 when viewed in cross-section to bond the present thermosetting sheet IIa (bonding sheet 11) and the upper metal-containing member 12 together.

In this regard, it is preferable that the present thermosetting sheet IIa (bonding sheet 11) is subjected to low-temperature aging in an environment of -50°C or higher and 0°C or lower beforehand, specifically before being laminated on the lower metal-containing member 13 as described above.

Note that the term "the present thermosetting sheet IIa (bonding sheet 11)" is used herein because the present thermosetting sheet IIa is also the bonding sheet 11.

The following provides a more detailed explanation.

First, it is preferable to laminate the present thermosetting sheet IIa (bonding sheet 11) on a lower metal-containing member 13 and apply a uniform pressure (first pressing) thereon to bond the lower metal-containing member 13 and the present thermosetting sheet IIa (bonding sheet 11) together.

In this regard, to ensure uniform pressure distribution, a cushioning material made of an arbitrary material, such as copy paper, a fluorine-based film such as Teflon, a silicone rubber sheet, carbon paper, or a graphite sheet, may be used.

Second, it is preferable to laminate an upper metal-containing member 12 on the present thermosetting sheet IIa (bonding sheet 11) and apply a uniform pressure (second pressing) thereon to bond the present thermosetting sheet IIa (bonding sheet 11) and the upper metal-containing member 12 together. That is, the region 11A of the present thermosetting sheet IIa (bonding sheet 11), which overlaps with both the upper metal-containing member 12 and the lower metal-containing member 13 when viewed in cross-section, is pressed, and the entire present thermosetting sheet IIa (bonding sheet 11) is heated for thermosetting and bonding the upper metal-containing member 12 and the lower metal-containing member 13 to the upper and lower surfaces of the bonded body sheet 1, thereby producing the present bonded body II.

In this regard, a plurality of upper metal-containing members 12 may be bonded together in a sheet form.

To ensure uniform pressure distribution, a cushioning material made of an arbitrary material, such as copy paper, a fluorine-based film such as Teflon, a silicone rubber sheet, carbon paper, or a graphite sheet, may be used.

For the first pressing, it is sufficient to be able to temporarily fix the present thermosetting sheet IIa (bonding sheet 11) on the lower metal-containing member 13, and it is thus preferable to apply a pressure such that a load of 0.5 MPa or more and 10 MPa or less is applied to the present thermosetting sheet IIa (bonding sheet 11), more preferably a load of 1 MPa or more or 9 MPa or less, and even more preferably a load of 2 MPa or more or 8 MPa or less.

By the second pressing, i.e., by applying a pressure to the region 11A of the present thermosetting sheet IIa (bonding sheet 11), which overlaps with both the upper metal-containing member 12 and the lower metal-containing member 13 when viewed in cross-section, the voids present in the region 11A can be crushed, thereby reducing the area ratio of the voids (void ratio X_{A}). Furthermore, thermal conductivity can be enhanced by reducing the void ratio without destroying the secondary particles of inorganic fillers, such as boron nitride agglomerated particles, and also by improving contact between the inorganic fillers to facilitate the formation of thermal conduction paths.

From such a viewpoint, it is desirable to apply a load of 2 MPa or more in the second pressing.

The load is preferably 4 MPa or more, more preferably 5 MPa or more, and even more preferably 6 MPa or more. On the other hand, the load is preferably 150 MPa or less, more preferably 100 MPa or less, and even more preferably 20 MPa or less.

In the second pressing, heating may also be performed simultaneously.

In this regard, the heating temperature (product temperature) is preferably 10°C or higher, more preferably 20°C or higher, and even more preferably 30°C or higher. The heating temperature is preferably 300°C or lower, more preferably 250°C or lower, and even more preferably 200°C or lower.

By performing the second pressing within the above temperature range, the melt viscosity of the resin in the present thermosetting sheet IIa (bonding sheet 11) can be reduced, thereby further reducing voids and air gaps within the thermosetting sheet IIa (bonding sheet 11). In addition, by heating at or below the aforementioned upper limit, voids caused by the decomposition of organic components or residual solvents in the present thermosetting sheet IIa (bonding sheet 11) tend to be suppressed.

As a specific example, both pressing and heating can be performed simultaneously by: pre-heating upper and lower platens of a press machine; laminating the upper metal-containing member 12 on the present thermosetting sheet IIa (bonding sheet 11), which has been laminated on the lower metal-containing member 13, to form a laminate; setting the laminate in the press machine; and pressing the laminate between the upper and lower platens. Alternatively, both pressing and heating can be performed simultaneously by: laminating the present thermosetting sheet IIa (bonding sheet 11) on the lower metal-containing member 13 and then laminating the upper metal-containing member 12 on the present thermosetting sheet IIa (bonding sheet 11) to form a laminate; setting the laminate in a press machine; and heating the press machine or its pressing portion to apply a pressure. In this regard, both the regions 11A and 11B of the present thermosetting sheet IIa (bonding sheet 11) are heated.

The temperature of the platens can be considered equivalent to the product temperature of the present thermosetting sheet IIa (bonding sheet 11).

The pressing time for the second pressing is not particularly limited. The time is preferably 30 seconds or more, more preferably 1 minute or more, even more preferably 3 minutes or more, and particularly preferably 5 minutes or more. The time for the pressing step is preferably 1 hour or less, more preferably 30 minutes or less, and even more preferably 20 minutes or less.

By setting the pressing time at or below the aforementioned upper limit, it is possible to reduce the production time, which tends to reduce the production cost. By setting the pressing time at or above the aforementioned lower limit, it is possible to sufficiently eliminate air gaps and voids within the present thermosetting sheet IIa (bonding sheet 11), which tends to improve the heat transfer performance and withstand voltage characteristics.

Alternatively, the present thermosetting sheet IIa (bonding sheet 11) may be heated for curing after the second pressing.

In this regard, the heating temperature (product temperature) is preferably 30°C to 400°C, more preferably 50°C or higher, and even more preferably 90°C or higher. On the other hand, it is preferably 300°C or lower, and more preferably 250°C or lower.

For the aforementioned pressing method, various conventionally known press machines for molding thermosetting resins can be used. From the viewpoint of preventing resin deterioration during heat-pressing, it is particularly preferable to use a vacuum press machine capable of reducing the amount of oxygen in the press machine during heating, or a press machine equipped with a nitrogen substitution apparatus.

As for the heating in the aforementioned method, a method such as controlling the temperature of the upper and lower platens of the press machine may be used.

It is preferable that the present thermosetting sheet IIa is subjected to low-temperature aging beforehand, specifically at least before being laminated on the lower metal-containing member 13.

For the low-temperature aging, for example, the present thermosetting sheet IIa may be exposed in an environment of preferably -50°C or higher and 0°C or lower, more preferably -30°C or higher or -5°C or lower, for a period of preferably 5 minutes or more and 365 days or less, more preferably 1 hour or more or 7 days or less.

No pressure is required during the low-temperature aging. However, a minute pressure of 0.1 kPa or less may be applied.

The timing for the low-temperature aging may be, for example, after coating, after heating and drying, or after pressing. Among these timings, after pressing is preferable. Note that the pressing in this regard refers not to the heat-pressing performed when producing the present bonded body II, but rather to the pressing performed beforehand when producing the present thermosetting sheet IIa.

By subjecting the present thermosetting sheet IIa to such low-temperature aging, the moisture inside the sheet can be frozen and dispersed as minute ice, and even after returning to room temperature, small chambers for the moisture that remains trapped in tiny spaces can be formed, which can suppress the occurrence of cracks when the sheet is bent due to moisture retention, while preventing the deterioration of insulating properties without generating large voids. Furthermore, minute voids are highly dispersed in the sheet, and thus the fluidity of the resin component can be increased during pressing, which facilitates the stacking of inorganic filler particles, such as boron nitride agglomerated particles, with each other, thereby achieving higher thermal conductivity and reducing the likelihood of cracks or deformations in the sheet due to the stress relaxation effect.

### <<Present Bonded Body III>>

A bonded body according to still another embodiment of the present invention (also referred to as "the present bonded body III") is a bonded body including two or more upper metal-containing members 22 each bonded to the upper surface of a bonding sheet 21 and a lower metal-containing member 23 bonded to the lower surface of the bonding sheet 21, wherein
the upper metal-containing members 22 and the lower metal-containing member 23 each have a metal portion in a bonding surface with the bonding sheet 21;
the bonding sheet 21 contains a thermosetting resin and an inorganic filler, and has voids therein;
when the bonded body is viewed in cross-section (thickness direction), the two or more upper metal-containing members 22 are each bonded to the bonding sheet 21 with a space portion 24 provided between adjacent upper metal-containing members 22; and
a ratio (T_{B}/T_{A}) of a thickness T_{B} of a region 21B to a thickness T_{A} of a region 21A is 1.02 or more, where T_{A} is a thickness of the region 21A of the bonding sheet 21 that is bonded to each of the upper metal-containing members 22, and T_{B} is a thickness of the region 21B of the bonding sheet 21 that is not bonded to each of the upper metal-containing members 22, i.e., the region 21B of the bonding sheet 21 at the space portion 24.

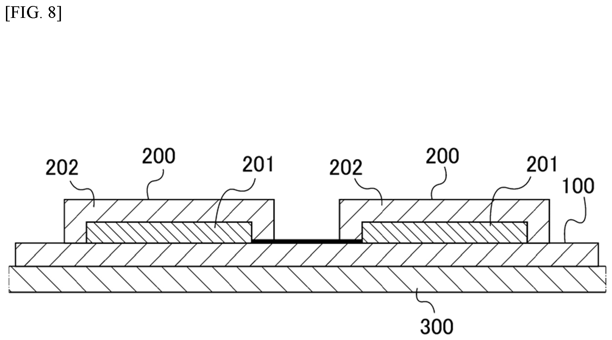

In a bonded body including two or more upper metal-containing member 200 (corresponding to the "electronic components, such as semiconductor elements") each bonded to a bonding sheet 100 (corresponding to the "insulating substrate") with a distance provided between adjacent upper metal-containing members 200 as shown in FIG. 8, when used for applications such as the power semiconductor devices described above, there has been a concern about creepage discharge when current is applied to the upper metal-containing members 200, because the creepage distance (shown by the bold line in FIG. 8), in other words, the conduction distance, between a conductor (metal portion) 201 included within one upper metal-containing member 200 and a conductor (metal portion) 201 included within the adjacent upper metal-containing member 200 is linear and short. Furthermore, in accordance with the demand for designing higher-output modules, it becomes necessary to bond a larger number of upper metal-containing members 200 on a single sheet, which may increasingly magnify the aforementioned concern.

Therefore, an object of the present bonded body III is to provide a novel bonded body and a method for producing the bonded body, wherein the bonded body, which includes two or more upper metal-containing members 22 each bonded to the upper surface of a bonding sheet 21 and a lower metal-containing member 23 bonded to the lower surface of the bonding sheet 21, can make a longer conduction distance (creepage distance) between a conductor (metal portion) included within one upper metal-containing member 22 and a conductor (metal portion) included within the adjacent upper metal-containing member 22 compared to the conventional example shown in FIG. 8.

In the present bonded body III including two or more upper metal-containing members 22 each bonded to the upper surface of a bonding sheet 21 and a lower metal-containing member 23 bonded to the lower surface of the bonding sheet 21, by bonding two or more upper metal-containing members 22 to the bonding sheet 21 with a space portion 24 provided between adjacent upper metal-containing members 22, and by providing a step difference such that an interface between each of the upper metal-containing members 22 and the bonding sheet 21 is positioned below a creepage surface of the space portion 24, the thickness T_{B} of the region 21B in the bonding sheet 21 that is not bonded to each of the upper metal-containing members 22, i.e., the region 21B of the bonding sheet 21 at the space portion 24, can be made larger than the thickness T_{A} of the region 21A in the bonding sheet 21 that is bonded to each of the upper metal-containing members 22; and preferably, the ratio (T_{B}/T_{A}) of the thickness T_{B} of the region 21B to the thickness T_{A} of the region 21A can be made 1.02 or more, which allows a conduction distance (creepage distance) between the metal portion of one upper metal-containing member 22 and the metal portion of the adjacent upper metal-containing member 22 to be made longer by a length of (TB - TA) × 2, compared to the conventional example shown in FIG. 8.

This configuration is expected to reduce the risk of creepage discharge when current is applied to the upper metal-containing members 22. Furthermore, for example when used in humid environments, it is possible to increase a penetration distance of atmospheric moisture to the bonding interface between the metal portion of each of the upper metal-containing members 22 and the bonding sheet 21, which can reduce the risk of moisture ingress and can be expected to mitigate the causes of failure. Moreover, positioning the interface between each of the upper metal-containing members 22 and the bonding sheet 21 below the creepage surface of the space portion 24 prevents discharge from the interface between one upper metal-containing member 22 and the bonding sheet 21 to the interface between the adjacent upper metal-containing member 22 and the bonding sheet 21 via the creepage discharge at the space portion 24, and it is also expected to make it even more difficult for atmospheric moisture to penetrate the interface between the metal portion, which is the conductor, included in each of the upper metal-containing members 22 and the sheet.

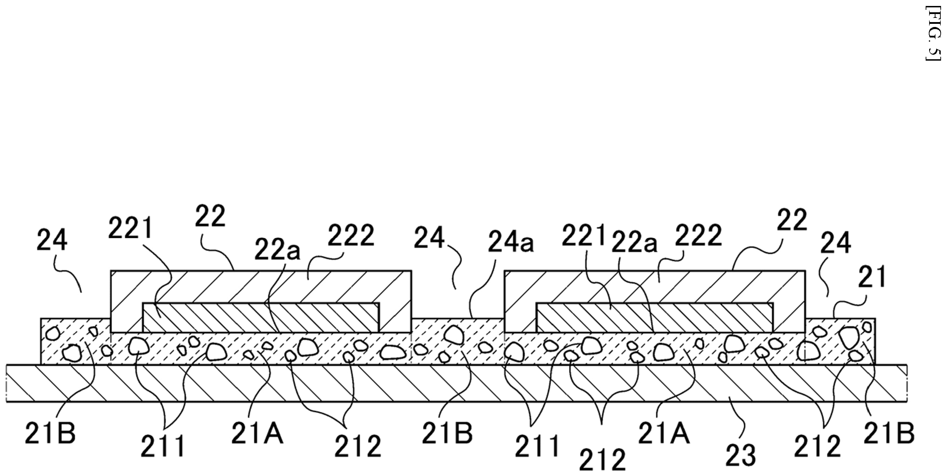

The present bonded body III is a bonded body including two or more upper metal-containing members 22 each bonded to the upper surface of a bonding sheet 21 and a lower metal-containing member 23 bonded to the lower surface of the bonding sheet 21, as shown in FIG. 5. Specifically, it is a bonded body including upper metal-containing members 22 each bonded to one side of a bonding sheet 21 and a lower metal-containing member 23 bonded to the other side of the bonding sheet 21.

In this regard, it is preferable that the bonding sheet 21 is directly bonded to the upper metal-containing members 22, and the bonding sheet 21 is directly bonded to the lower metal-containing member 23. As used herein, the term "directly bonded" means being bonded without any other members in between, and without the use of adhesives (including solder). However, the term "directly bonded" is considered to include cases where the bonding surfaces of the bonding sheet 21 with the upper metal-containing members 22 and the lower metal-containing member 23 are subjected to a thin-layer surface treatment, such as plating including nickel plating or tin plating, chemical treatment, or physical treatment, which will be described later.

In the present bonded body III, as shown in FIG. 5, when the bonded body is viewed in cross-section (thickness direction), two or more upper metal-containing members 22 are bonded to the bonding sheet 21 with a space portion 24 provided between adjacent upper metal-containing members 22, and the bonding sheet 21 has a region 21A that is bonded to each of the upper metal-containing members 22, in other words, a region 21A that is sandwiched between both each of the upper metal-containing members 22 and the lower metal-containing member 23, and a region 21B that is not bonded to each of the upper metal-containing members 22, in other words, a region 21B at the space portion 24.

In the present invention, the term "cross-section" in the "when the bonded body is viewed in cross-section (thickness direction)" refers to a cross-section cut in the thickness direction along the length or width direction of the bonding sheet 21.

The bonding surfaces of the bonding sheet 21, the upper metal-containing members 22, and the lower metal-containing member 23 may be flat surfaces as shown in FIG. 5. However, each of the bonding surfaces may have a recess or a protrusion.

### (Space Portion)

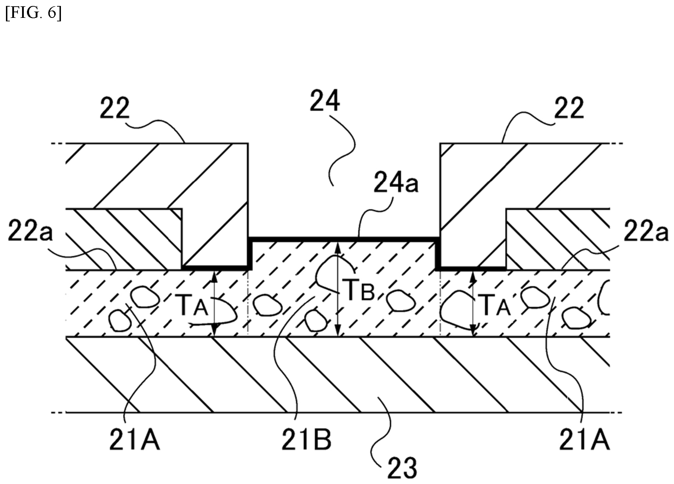

When the present bonded body III includes two or more upper metal-containing members 22 each bonded to the upper surface of the bonding sheet 21, by bonding two or more upper metal-containing members 22 to the bonding sheet 21 with a space portion 24 provided between adjacent upper metal-containing members 22, and by providing a step difference such that an interface 22a between each of the upper metal-containing members 22 and the bonding sheet 21 is positioned below a creepage surface 24a of the space portion 24 as shown in FIG. 6, the thickness T_{B} of the region 21B in the bonding sheet 21 that is not bonded to each of the upper metal-containing members 22, i.e., the region 21B of the bonding sheet 21 at the space portion 24, can be made larger than the thickness T_{A} of the region 21A in the bonding sheet 21 that is bonded to each of the upper metal-containing members 22; and preferably, the ratio (T_{B}/T_{A}) of the thickness T_{B} of the region 21B to the thickness T_{A} of the region 21A can be made 1.02 or more, which allows a conduction distance, in other words, a creepage distance (shown by the bold line in FIG. 6) between the metal portion of one upper metal-containing member 22 and the metal portion of the adjacent upper metal-containing member 22 to be made longer by a length of (TB - TA) × 2 as shown in FIG. 6, compared to the conventional example shown in FIG. 8. This configuration is expected to reduce the risk of creepage discharge when current is applied to the upper metal-containing members 22. Furthermore, for example when used in humid environments, it is possible to increase a penetration distance of atmospheric moisture to the bonding interface between the metal portion of each of the upper metal-containing members 22 and the bonding sheet 21, which can reduce the risk of moisture ingress and can be expected to mitigate the causes of failure. Moreover, positioning the interface 22a between each of the upper metal-containing members 22 and the bonding sheet 21 below the creepage surface 24a of the space portion 24 prevents discharge from the interface 22a between one upper metal-containing member 22 and the bonding sheet 21 to the interface 22a between the adjacent upper metal-containing member 22 and the bonding sheet 21 via the creepage surface 24a of the space portion 24, and it is also expected to make it even more difficult for atmospheric moisture to penetrate the interface between the metal portion, which is the conductor, included in each of the upper metal-containing members 22 and the sheet.

The width of the space portion 24 provided between one upper metal-containing member 22 and the adjacent upper metal-containing member 22, i.e., the lateral distance between adjacent upper metal-containing members 22, is preferably 1 mm or more, more preferably 2 mm or more, and even more preferably 3 mm or more, from the viewpoint of ensuring the creepage distance. On the other hand, from the viewpoint of increasing the input power to one module by bonding many members on the same sheet, it is preferably 100 mm or less, more preferably 50 mm or less, and even more preferably 30 mm or less.

The ratio (space portion 24/upper metal-containing member 22) of the width of the space portion 24, i.e., the lateral distance between the adjacent upper metal-containing members 22, to the width of the upper metal-containing member 22 is preferably 0.05 or more, more preferably 0.07 or more, and even more preferably 0.1 or more, from the viewpoint of ensuring the creeping distance. On the other hand, from the viewpoint of increasing the input power to one module by bonding many members on the same sheet, it is preferably 10 or less, more preferably 5 or less, and even more preferably 3 or less.

### (Thickness of Bonding Sheet 21)

The present bonded body III is characterized in that, when the bonded body is viewed in cross-section (thickness direction), the thickness T_{B} of the region 21B in the bonding sheet 21 that is not bonded to each of the upper metal-containing members 22, i.e., the region 21B of the bonding sheet 21 at the space portion 24, is larger than the thickness T_{A} of the region 21A in the bonding sheet 21 that is bonded to each of the upper metal-containing members 22, and preferably, the ratio (T_{B}/T_{A}) of the thickness T_{B} of the region 21B to the thickness T_{A} of the region 21A is 1.02 or more.

By making the thickness T_{B} of the region 21B larger than the thickness T_{A} of the region 21A, preferably by setting the ratio (T_{B}/T_{A}) of the thickness T_{B} of the region 21B to the thickness T_{A} of the region 21A to be 1.02 or more, the conduction distance (creepage distance) between the metal portion, which is the conductor, included in one upper metal-containing member 22 and the metal portion, which is the conductor, included in the adjacent upper metal-containing member 22 can be ensured, which not only reduces the risk of creepage discharge but is also expected to make it even more difficult for atmospheric moisture to penetrate into the interface between the metal portion, which is the conductor, included in each of the upper metal-containing members 22 and the sheet. Furthermore, positioning the interface 22a between each of the upper metal-containing members 22 and the bonding sheet 21 below the creepage surface 24a of the space portion 24 prevents discharge from the interface 22a between one upper metal-containing member 22 and the bonding sheet 21 to the interface 22a between the adjacent upper metal-containing member 22 and the bonding sheet 21 via the creepage discharge at the space portion 24, and it is also expected to make it even more difficult for atmospheric moisture to penetrate the interface between the metal portion, which is the conductor, included in each of the upper metal-containing members 22 and the sheet.

From such a viewpoint, the ratio (T_{B}/T_{A}) of the thickness T_{B} of the region 21B to the thickness T_{A} of the region 21A is preferably 1.02 or more, more preferably 1.03 or more, even more preferably 1.05 or more, still more preferably 1.10 or more, and still more preferably 1.14 or more. However, if the ratio (T_{B}/T_{A}) is too large, the distance from the metal portion, which is the conductor, included in each of the upper metal-containing members 22 to the lower metal-containing member 23 becomes short, leading to concerns about the risk of dielectric breakdown in the thickness direction of the sheet. Therefore, the ratio (T_{B}/T_{A}) is preferably 1.4 or less, more preferably 1.3 or less, and even more preferably 1.2 or less.

From the same viewpoint, the difference (T_{B} - T_{A}) between the thickness T_{A} of the region 21A and the thickness T_{B} of the region 21B is preferably 3 µm or more, more preferably 4 µm or more, even more preferably 5 µm or more, still more preferably 10 µm or more, still more preferably 15 µm or more, and still more preferably 19 µm or more. However, if the difference (T_{B} - T_{A}) is too large, the distance from the metal portion, which is the conductor, included in each of the upper metal-containing members 22 to the lower metal-containing member 23 becomes short, leading to concerns about the risk of dielectric breakdown in the thickness direction of the sheet. Therefore, the difference (T_{B} - T_{A}) is preferably 30 µm or less, more preferably 25 µm or less, and even more preferably 20 µm or less.

To adjust the relationship between the thickness T_{A} of the region 21A and the thickness T_{B} of the region 21B in the bonding sheet 21 as described above, upper metal-containing members 22 may be laminated on the upper surface of a present thermosetting sheet IIIa described below, and the region 21A of the bonding sheet 21 may be pressed and pushed into the present thermosetting sheet IIIa, followed by heating and curing the present thermosetting sheet IIIa. In addition, adjustments may be made to the type of thermosetting resin, the type of inorganic filler, and the presence or absence and conditions of low-temperature aging. The present invention, however, is not limited to such methods.

The method for measuring the thickness T_{A} of the region 21A and the thickness T_{B} of the region 21B is not particularly limited, and the thicknesses may be measured using a thickness gauge such as a micrometer by separating only the bonding sheet 21 from the bonded body, or measured from a cross-sectional photograph obtained using a scanning electron microscope (SEM) or the like.

The thickness T_{A} of the region 21A in the bonding sheet 21 is not particularly limited.

In the case where the present bonded body III is used for applications such as power semiconductor devices, industrial equipment, in-vehicle equipment, and power generation energy, the thickness T_{A} of the region 21A in the bonding sheet 21 is preferably 80 µm or more, more preferably 100 µm or more, even more preferably 110 µm or more, and still more preferably 120 µm or more. On the other hand, the upper limit of the thickness T_{A} is preferably 300 µm or less, more preferably 250 µm or less, even more preferably 220 µm or less, still more preferably 200 µm or less, and still more preferably 180 µm or less.

By setting the thickness T_{A} of the region 21A in the bonding sheet 21 to 80 µm or more, it is possible to not only ensure high heat dissipation but also ensure sufficient withstand voltage characteristics. On the other hand, by setting the thickness thereof to 300 µm or less, it is possible to achieve a reduction in size or thickness of the present bonded body III and to reduce thermal resistance in the thickness direction through the thinning, compared to an insulating thermally conductive layer made of a ceramic material.

### (Thermal Conductivity)

In the case where the present bonded body III is used for applications such as power semiconductor devices, industrial equipment, in-vehicle equipment, and power generation energy, the bonding sheet 21 preferably has a thermal conductivity in the thickness direction in the region 21A of 10 W/m·K or more, more preferably 11 W/m·K or more, and even more preferably 12 W/m·K or more. On the other hand, it is preferably 25 W/m·K or less, and more preferably 20 W/m·K or less.

To adjust the thermal conductivity in the region 21A of the bonding sheet 21 as described above, using a method in which upper metal-containing members 22 and a lower metal-containing member 23 are laminated, respectively, on the upper and lower surfaces of a present thermosetting sheet IIIa described below, the region 21A of the bonding sheet 21 is pressed, and the present thermosetting sheet IIIa is heated and cured, adjustments may be made to the pressing conditions, the type of thermosetting resin, the type of inorganic filler, and the presence or absence and conditions of low-temperature aging. The present invention, however, is not limited to such methods.

The thermal conductivity in the thickness direction in the region 21A of the bonding sheet 21 can be measured by the following method. For example, the thermal conductivity can be determined from the slope of a graph plotting the thermal resistance values against the thicknesses using a thermal resistance measuring device.

In this regard, the thermal conductivity in the thickness direction in the region 21A may be measured by separating only the bonding sheet 21 from the bonded body. In Example III-1 described below, a bonding sheet is produced with the same composition and under the same pressing and heating conditions as in Example III-1, and the thermal conductivity in the thickness direction in the region 21A is measured.

### (Dielectric Breakdown Voltage (BDV))

In the case where the present bonded body III is used for applications such as power semiconductor devices, industrial equipment, in-vehicle equipment, and power generation energy, the bonding sheet 21 preferably has a dielectric breakdown voltage in the region 21A of 5 kV or more, more preferably 5.5 kV or more, and even more preferably 6 kV or more. A higher dielectric breakdown voltage is more preferable, and there is no particular upper limit.

To adjust the dielectric breakdown voltage in the region 21A of the bonding sheet 21 as described above, using a method in which upper metal-containing members 22 and a lower metal-containing member 23 are laminated, respectively, on the upper and lower surfaces of a present thermosetting sheet IIIa described below, the region 21A of the bonding sheet 21 is pressed, and the present thermosetting sheet IIIa is heated and cured, adjustments may be made to the pressing conditions, the type of thermosetting resin, the type of inorganic filler, and the presence or absence and conditions of low-temperature aging. The present invention, however, is not limited to such methods.

The dielectric breakdown voltage in the region 21A of the bonding sheet 21 can be measured by applying a voltage in the thickness direction of the bonded body.

### <Upper Metal-Containing Member 22 and Lower Metal-Containing Member 23>

Both the upper metal-containing member 22 and the lower metal-containing member 23 are the same as the upper metal-containing member 2 and the lower metal-containing member 3 of the present bonded body I, respectively. That is, the upper metal-containing member 2 of the present bonded body I is read as the upper metal-containing member 22 of the present bonded body III, and the lower metal-containing member 3 of the present bonded body I is read as the lower metal-containing member 23 of the present bonded body III. Similarly, the metal portion 25, resin 26, semiconductor chip 27, and wiring member 28 in the present bonded body I are read as the metal portion 221, resin 222, semiconductor chip 223, and wiring member 224, respectively.

### <Bonding Sheet 21>

The bonding sheet 21 contains a thermosetting resin and an inorganic filler 211, and has voids 212 therein.

The bonding sheet 21 is a cured product of a thermosetting resin composition (referred to as "the present thermosetting resin composition IIIb") containing a thermosetting resin and an inorganic filler. Specifically, the bonding sheet 21 is a cured product of a thermosetting sheet (referred to as "the present thermosetting sheet IIIa") formed by molding the present thermosetting resin composition IIIb into a sheet.

### (Present Thermosetting Resin Composition IIIb)

The composition of the thermosetting resin composition for forming the bonding sheet 21 is the same as that of the thermosetting resin composition for forming the bonding sheet 1. That is, the present thermosetting resin composition IIIb is the same as the present thermosetting resin composition Ib in the bonding sheet 1.

### <Method for Producing Present Bonded Body III>

Next, a method for producing the present bonded body III will be described.

A method for producing the present bonded body III includes a method of arranging the present thermosetting sheet IIIa (bonding sheet 21) between upper metal-containing members 22 and a lower metal-containing member 23 and controlling pressing conditions such as press pressure, press temperature, and press configuration; or a method of previously preparing a bonding sheet 21 having regions with different degrees of deformation under pressure and arranging the bonding sheet 21 between upper metal-containing members 2 and a lower metal-containing member 23. The former method of controlling the pressing conditions is preferable.

The method described below is merely an example of a method for producing the present bonded body III, and is not limited to the following method.

An example of the method for producing the present bonded body III may include: laminating the present thermosetting sheet IIIa (bonding sheet 21), which is formed by molding the present thermosetting resin composition IIIb containing a thermosetting resin and an inorganic filler into a sheet, on a lower metal-containing member 23; applying a uniform pressure thereon to bond the lower metal-containing member 23 and the present thermosetting sheet IIIa (bonding sheet 21) together; subsequently laminating two or more upper metal-containing members 22 on the present thermosetting sheet IIIa (bonding sheet 21); applying a pressure to a region 21A that overlaps with both the upper metal-containing members 22 and the lower metal-containing member 23 when viewed in cross-section to push the upper metal-containing members 22 into the present thermosetting sheet IIIa (bonding sheet 21) such that an interface 22a between each of the upper metal-containing members 22 and the present thermosetting sheet IIIa (bonding sheet 21) is positioned below a creepage surface 24a of a space portion 24; and bonding the present thermosetting sheet IIIa (bonding sheet 21) and the upper metal-containing members 22 together.

In this regard, it is preferable that the present thermosetting sheet IIIa (bonding sheet 21) is subjected to low-temperature aging in an environment of -50°C or higher and 0°C or lower beforehand, specifically before being laminated on the lower metal-containing member 23 as described above.

Note that the term "the present thermosetting sheet IIIa (bonding sheet 21)" is used herein because the present thermosetting sheet IIIa is also the bonding sheet 21.

The following provides a more detailed explanation.

First, it is preferable to laminate the present thermosetting sheet IIIa (bonding sheet 21) on a lower metal-containing member 23 and apply a uniform pressure (first pressing) thereon to bond the lower metal-containing member 23 and the present thermosetting sheet IIIa (bonding sheet 21) together.

In this regard, to ensure uniform pressure distribution, a cushioning material made of an arbitrary material, such as copy paper, a fluorine-based film such as Teflon, a silicone rubber sheet, carbon paper, or a graphite sheet, may be used.

Second, it is preferable to laminate two or more upper metal-containing members 22 on the present thermosetting sheet IIIa (bonding sheet 21) with a predetermined distance provided between adjacent upper metal-containing members 22, and then further apply a uniform pressure (second pressing) thereon to bond the present thermosetting sheet IIIa (bonding sheet 21) and the upper metal-containing members 22 together. That is, the region 21A of the present thermosetting sheet IIIa (bonding sheet 21), which overlaps with both the upper metal-containing member 22 and the lower metal-containing member 23 when viewed in cross-section, is pressed to push the upper metal-containing members 22 into the present thermosetting sheet IIIa (bonding sheet 21), in other words, to push the upper metal-containing members 22 into the present thermosetting sheet IIIa (bonding sheet 21) such that the upper surface thereof is recessed, and an interface 22a between each of the upper metal-containing members 22 and the present thermosetting sheet IIIa (bonding sheet 21) is positioned below a creepage surface 24a of a space portion 24, and the entire present thermosetting sheet IIIa (bonding sheet 21) is heated for thermosetting and bonding the upper metal-containing members 22 and the lower metal-containing member 13 to the upper and lower surfaces of the present thermosetting sheet IIIa (bonding sheet 21), thereby producing the present bonded body III.

In this regard, by arranging and laminating two or more upper metal-containing members 22 with a predetermined distance provided between adjacent upper metal-containing members 22, the two or more upper metal-containing members 22 can each be bonded to the present thermosetting sheet IIIa (bonding sheet 21) with a space portion 24 provided between adjacent upper metal-containing members 22.

Furthermore, by applying a pressure to push the upper metal-containing members 22 into the present thermosetting sheet IIIa (bonding sheet 21) such that an interface 22a between each of the upper metal-containing members 22 and the present thermosetting sheet IIIa (bonding sheet 21) is positioned below a creepage surface 24a of a space portion 24, the thickness T_{B} of the region 21B in the bonding sheet 21 that is not bonded to each of the upper metal-containing members 22, i.e., the region 21B of the bonding sheet 21 at the space portion 24, can be made larger than the thickness T_{A} of the region 21A in the bonding sheet 21, and preferably, the ratio (T_{B}/T_{A}) of the thickness T_{B} of the region 21B to the thickness T_{A} of the region 21A can be made 1.02 or more.

The distance between the adjacent upper metal-containing members 22, in other words, the width of the space portion 24, is preferably 2 mm or more, more preferably 3 mm or more, and even more preferably 4 mm or more, from the viewpoint of ensuring the creepage distance as described above. On the other hand, from the viewpoint of increasing the input power to one module by bonding many members on the same sheet, it is preferably 100 mm or less, more preferably 50 mm or less, and even more preferably 30 mm or less.

The two or more upper metal-containing members 22 may be the same or different from each other.

To ensure uniform pressure distribution, a cushioning material made of an arbitrary material, such as copy paper, a fluorine-based film such as Teflon, a silicone rubber sheet, carbon paper, or a graphite sheet, may be used.

For the first pressing, it is sufficient to be able to temporarily fix the present thermosetting sheet IIIa (bonding sheet 21) on the lower metal-containing member 23, and it is thus preferable to apply a pressure such that a load of 0.5 MPa or more and 10 MPa or less is applied to the present thermosetting sheet IIIa (bonding sheet 21), more preferably a load of 1 MPa or more or 9 MPa or less, and even more preferably a load of 2 MPa or more or 8 MPa or less.

By the second pressing, i.e., by applying a pressure to a region 21A of the present thermosetting sheet IIIa (bonding sheet 21), which overlaps with both the upper metal-containing members 22 and the lower metal-containing member 23 when viewed in cross-section, to push the upper metal-containing members 22 into the present thermosetting sheet IIIa (bonding sheet 21) such that an interface 22a between each of the upper metal-containing members 22 and the present thermosetting sheet IIIa (bonding sheet 21) is positioned below a creepage surface 24a of a space portion 24, the thickness T_{A} of the region 21A can be made smaller than the thickness T_{B} of the region 21B in the bonding sheet 21.

From such a viewpoint, it is desirable to apply a load of 2 MPa or more in the second pressing.

The load is preferably 4 MPa or more, more preferably 5 MPa or more, and even more preferably 6 MPa or more. On the other hand, the load is preferably 150 MPa or less, more preferably 100 MPa or less, and even more preferably 20 MPa or less.

In the second pressing, heating may also be performed simultaneously.

In this regard, the heating temperature (product temperature) is preferably 10°C or higher, more preferably 20°C or higher, and even more preferably 30°C or higher. The heating temperature is preferably 300°C or lower, more preferably 250°C or lower, and even more preferably 200°C or lower.

By performing the second pressing within the above temperature range, the melt viscosity of the resin in the present thermosetting sheet IIIa (bonding sheet 21) can be reduced, thereby further reducing voids and air gaps within the thermosetting sheet IIIa (bonding sheet 21). In addition, by heating at or below the aforementioned upper limit, voids caused by the decomposition of organic components or residual solvents in the present thermosetting sheet IIIa (bonding sheet 21) tend to be suppressed.

As a specific example, both pressing and heating can be performed simultaneously by: pre-heating upper and lower platens of a press machine; laminating the upper metal-containing members 22 on the present thermosetting sheet IIIa (bonding sheet 21), which has been laminated on the lower metal-containing member 23, to form a laminate; setting the laminate in the press machine; and pressing the laminate between the upper and lower platens. Alternatively, both pressing and heating can be performed simultaneously by: laminating the present thermosetting sheet IIIa (bonding sheet 21) on the lower metal-containing member 23 and then laminating the upper metal-containing members 22 on the present thermosetting sheet IIIa (bonding sheet 21) to form a laminate; setting the laminate in a press machine; and heating the press machine or its pressing portion to apply a pressure. In this regard, both the regions 21A and 21B of the present thermosetting sheet IIIa (bonding sheet 21) are heated.

The temperature of the platens can be considered equivalent to the product temperature of the present thermosetting sheet IIIa (bonding sheet 21).

The pressing time for the second pressing is not particularly limited. The time is preferably 30 seconds or more, more preferably 1 minute or more, even more preferably 3 minutes or more, and particularly preferably 5 minutes or more. The time for the pressing step is preferably 1 hour or less, more preferably 30 minutes or less, and even more preferably 20 minutes or less.

By setting the pressing time at or below the aforementioned upper limit, it is possible to reduce the production time, which tends to reduce the production cost. By setting the pressing time at or above the aforementioned lower limit, it is possible to sufficiently eliminate air gaps and voids within the present thermosetting sheet IIIa (bonding sheet 21), which tends to improve the heat transfer performance and withstand voltage characteristics.

Alternatively, the present thermosetting sheet IIIa (bonding sheet 21) may be heated for curing after the second pressing.

In this regard, the heating temperature (product temperature) is preferably 30°C to 400°C, more preferably 50°C or higher, and even more preferably 90°C or higher. On the other hand, it is preferably 300°C or lower, and more preferably 250°C or lower.

For the aforementioned pressing method, various conventionally known press machines for molding thermosetting resins can be used. From the viewpoint of preventing resin deterioration during heat-pressing, it is particularly preferable to use a vacuum press machine capable of reducing the amount of oxygen in the press machine during heating, or a press machine equipped with a nitrogen substitution apparatus.

As for the heating in the aforementioned method, a method such as controlling the temperature of the upper and lower platens of the press machine may be used.

It is preferable that the present thermosetting sheet IIIa is subjected to low-temperature aging beforehand, specifically at least before being laminated on the lower metal-containing member 23.

For the low-temperature aging, for example, the present thermosetting sheet IIIa may be exposed in an environment of preferably -50°C or higher and 0°C or lower, more preferably -30°C or higher or -5°C or lower, for a period of preferably 5 minutes or more and 365 days or less, more preferably 1 hour or more or 7 days or less.

No pressure is required during the low-temperature aging. However, a minute pressure of 0.1 kPa or less may be applied.

The timing for the low-temperature aging may be, for example, after coating, after heating and drying, or after pressing. Among these timings, after pressing is preferable. Note that the pressing in this regard refers not to the heat-pressing performed when producing the present bonded body III, but rather to the pressing performed beforehand when producing the present thermosetting sheet IIIa.

By subjecting the present thermosetting sheet IIIa to such low-temperature aging, the moisture inside the sheet can be frozen and dispersed as minute ice, and even after returning to room temperature, small chambers for the moisture that remains trapped in tiny spaces can be formed, which can suppress the occurrence of cracks when the sheet is bent due to moisture retention, while preventing the deterioration of insulating properties without generating large voids.

Furthermore, by performing the low-temperature aging, minute voids can be highly dispersed within the sheet, which can increase the fluidity of the resin component during pressing. As a result, it is considered that inorganic filler particles, such as boron nitride agglomerated particles, tend to stack with each other, making it easier for a thickness difference to form between the region 21A and the region 21B, which allows the ratio (T_{B}/T_{A}) of the thickness T_{B} of the region 21B to the thickness T_{A} of the region 21A to be 1.02 or more, thereby lengthening the conduction distance (creepage distance) and suppressing a decrease in the dielectric breakdown voltage (BDV).

### <Explanation of Terms and Phrases>

In the present invention, the term "film" is intended to encompass "sheet", and the term "sheet" is intended to encompass "film".

In the case of being described as the phrase "α to β" (α and β are arbitrary numbers) in the present invention, the phrase encompasses the meaning of "preferably more than α" or "preferably less than β" along with the meaning "α or more and β or less", unless otherwise stated.

Also, the phrase "α or more" or "α ≤" (α is an arbitrary number) encompasses the meaning of "preferably more than α", and the phrase "β or less" or "≤ β" (β is an arbitrary number) encompasses the meaning of "preferably less than β", unless otherwise stated.

### EXAMPLES

Examples of the present invention will be described below. The present invention, however, is not limited to the following Examples.

### <Examples and Comparative Examples of Present Bonded Body I>

Example I-1 and Comparative Examples I-1 to I-2 of the present bonded body I will be described below.

### (Upper Metal-Containing Member 2)

As the upper metal-containing member 2, a member having dimensions of 21 mm in length, 16 mm in width, and 5 mm in thickness was provided, in which the periphery, excluding the bottom surface, of a copper plate serving as the metal portion 25 and having dimensions of 16 mm in length, 13 mm in width, and 2 mm in thickness was coated with epoxy resin serving as the resin 26.

### (Lower Metal-Containing Member 3)

As the lower metal-containing member 3, a copper plate having dimensions of 40 mm in length, 80 mm in width, and 2 mm in thickness was provided.

### (Production of Thermosetting Sheet 1a)

The following components were mixed using a planetary centrifugal mixer by adding methyl ethyl ketone and cyclohexanone to achieve a solid content concentration of 74% by mass, thereby preparing a slurry-form thermosetting resin composition: 9 parts by mass of high-molecular-weight epoxy resin (mass average molecular weight in polystyrene equivalent: 30,000, epoxy equivalent: 9,000 g/eq, density: approximately 1.2 g/cm³); 7 parts by mass of polyfunctional epoxy resin containing a structure with four or more glycidyl groups per molecule (molecular weight: 500 or less; density: approximately 1.2 g/cm³); 15 parts by mass of biphenyl-type solid epoxy resin (molecular weight: approximately 400, density: approximately 1.2 g/cm³); 63 parts by mass of spherical boron nitride agglomerated particles having a card-house structure (average particle diameter (D50): 45 µm, maximum particle diameter (Dmax): 90 µm); 5 parts by mass of a phenol resin-based curing agent, 0.4 parts by mass of a curing catalyst (2,4-diamino-6-[2'-ethyl-4'-methylimidazolyl-(17')]-ethyl-s-triazine, molecular weight: 247, properties: solid, melting point: 215°C to 225°C); and 0.4 parts by mass of a curing catalyst (2-phenyl-4,5-dihydroxymethylimidazole, molecular weight: 204; properties: solid; melting point: dec. 230, thus 230°C or higher).

The maximum particle diameter (Dmax) and the average particle diameter (D50) of the boron nitride agglomerated particles were the maximum particle diameter Dmax and the 50% cumulative volume particle diameter (average particle diameter D50) determined from the volume-based particle size distribution, which was obtained using a laser diffraction/scattering particle size analyzer LA-300 (manufactured by Horiba, Ltd.) after dispersing the boron nitride agglomerated particles in a pure water medium containing sodium hexametaphosphate as a dispersion stabilizer.

The slurry-form thermosetting resin composition obtained as described above was coated onto a PET substrate using the doctor blade method, and after heat-drying at 60°C (ambient temperature) for 120 minutes, a pressure was applied thereon using a press machine at 42°C (product temperature) and 1,500 kgf/cm² for 10 minutes to obtain a sheet-form resin composition with dimensions of 20 mm in length, 15 mm in width, and 150 µm in thickness (referred to as "the thermosetting sheet 1a").

The total content of methyl ethyl ketone and cyclohexanone in the thermosetting sheet 1a was 1% by mass or less.

The thermosetting sheet 1a obtained above was subjected to low-temperature aging in a freezer at -20°C for 2 days without applying any specific load, thereby obtaining a thermosetting sheet 1a.

### <Example I-1>

Using the aforementioned upper metal-containing member 2, lower metal-containing member 3, and thermosetting sheet 1a, a bonded body was produced as follows.

The thermosetting sheet 1a was laminated on the lower metal-containing member 3 such that the entire lower surface of the thermosetting sheet 1a overlapped the lower metal-containing member 3 to form a laminate, and copy paper was placed on the top and bottom of the laminate, respectively. The resulting laminate was set in a press machine with the upper and lower platens pre-heated to 80°C, and then heat-pressed at 80°C (product temperature) under a load of 2 MPa for 5 minutes.

Subsequently, the upper metal-containing member 2 was laminated on the thermosetting sheet 1a, which had been laminated on the lower metal-containing member 3, such that the entire upper surface of the thermosetting sheet 1a overlapped the upper metal-containing member 2 and the entire bottom surface of the metal portion of the upper metal-containing member 2 overlapped the sheet 1a to form a laminate, and copy paper was further placed on the top and bottom of the laminate, respectively. The resulting laminate was set in a press machine with the upper and lower platens pre-heated to 180°C, and then heat-pressed at 180°C (product temperature) under a load of 6 MPa for 30 minutes, thereby obtaining a bonded body including the upper metal-containing member 2 and the lower metal-containing member 3 bonded, respectively, to the upper and lower surfaces of the bonding sheet 1 having a thickness of 150 µm, as shown in FIG. 1.

In a cross-sectional view of the bonding sheet 1, the resin area ratio P_{1A} in the end region 1A extending 300 µm inward from either the left or right end of the bonding sheet 1 was 51%, the resin area ratio P_{1B} in the central region 1B was 45%, and the ratio of the two (P_{1A}/P_{1B}) was 1.13.

The void area ratio S_{1A} in the end region 1A was 5.5%, the void area ratio S_{1B} in the central region 1B was 0.8%, and the ratio of the two (S_{1A}/S_{1B}) was 6.8.

The void average size L_{1A} in the end region 1A was 14 µm²/number, the void average size L_{1B} in the central region 1B was 1.6 µm²/number, and the ratio of the two (L_{1A}/L_{1B}) was 8.75.

The area of the metal portion exposed on the lower surface of the upper metal-containing member 2 was 68% of the area of the bonding sheet 1 and 68% of the central region 1B of the bonding sheet 1, and the entire surface of the metal portion was in contact with the central region 1B of the bonding sheet 1.

The dielectric breakdown voltage (BDV) of the bonding sheet 1 was confirmed to be 5 kV or more.

The thermal conductivity in the thickness direction in the bonding sheet 1 was 14 W/m·K.

The bonding sheet 1 was observed using the ultrasonic imaging system for cracks or deformations during the production, as well as for the interface between the metal portions (upper metal-containing member 2 and lower metal-containing member 3) and the bonding sheet 1. Neither cracks nor deformations were found, and no peeling was observed at the interface.

The dielectric breakdown voltage (BDV) of the bonding sheet 1 after the thermal cycle test was confirmed to be 5 kV or more.

After the thermal cycle test, the bonding sheet 1 was observed using the ultrasonic imaging system for cracks or deformations due to temperature changes after the production, as well as for the interface between the metal portions (upper metal-containing member 2 and lower metal-containing member 3) and the bonding sheet 1. Neither cracks nor deformations were found, and no peeling was observed at the interface.

### <Comparative Example 1-1>

In the production of the aforementioned thermosetting sheet 1a, aging was performed in a 100°C environment for 1 hour, instead of the low-temperature aging in a freezer at -20°C for 2 days, to obtain a thermosetting sheet. A bonded body was then produced in the same manner as in Example I-1, except that the thermosetting sheet was used.

In a cross-sectional view of the bonding sheet 1 in the bonded body, the resin area ratio P_{1A} in the end region 1A extending 300 µm inward from either the left or right end of the bonding sheet 1 was 42%, the resin area ratio P_{1B} in the central region 1B was 44%, and the ratio of the two (P_{1A}/P_{1B}) was 0.95.

The void area ratio S_{1A} in the end region 1A was 7.0%, the void area ratio S_{1B} in the central region 1B was 7.9%, and the ratio of the two (S_{1A}/S_{1B}) was 0.89.

The void average size L_{1A} in the end region 1A was 109 µm²/number, the void average size L_{1B} in the central region 1B was 55 µm²/number, and the ratio of the two (L_{1A}/L_{1B}) was 1.98.

The area of the metal portion exposed on the lower surface of the upper metal-containing member 2 was 68% of the area of the bonding sheet and 68% of the central region 1B of the bonding sheet 1, and the entire surface of the metal portion was in contact with the central region 1B of the bonding sheet.

The dielectric breakdown voltage (BDV) of the bonding sheet 1 after the thermal cycle test was confirmed to be less than 5 kV.

After the thermal cycle test, the bonding sheet 1 was observed using the ultrasonic imaging system for cracks or deformations due to temperature changes after the production, as well as for the interface between the metal portions (upper metal-containing member 2 and lower metal-containing member 3) and the bonding sheet 1. Cracks and deformations were found, and peeling was also observed at the interface.

### <Comparative Example I-2>

In the production of the aforementioned thermosetting sheet 1a, aging was performed in a 60°C environment for 3 days, instead of the low-temperature aging in a freezer at -20°C for 2 days, to obtain a thermosetting sheet. A bonded body was then produced in the same manner as in Example I-1, except that the thermosetting sheet was used.

In a cross-sectional view of the bonding sheet 1 in the bonded body, the resin area ratio P_{1A} in the end region 1A extending 300 µm inward from either the left or right end of the bonding sheet 1 was 40%, the resin area ratio P_{1B} in the central region 1B was 37%, and the ratio of the two (P_{1A}/P_{1B}) was 1.08.

The void area ratio S_{1A} in the end region 1A was 6.6%, the void area ratio S_{1B} in the central region 1B was 12%, and the ratio of the two (S_{1A}/S_{1B}) was 0.55.

The void average size L_{1A} in the end region 1A was 108 µm²/number, the void average size L_{1B} in the central region 1B was 85 µm²/number, and the ratio of the two (L_{1A}/L_{1B}) was 1.27.

The area of the metal portion exposed on the lower surface of the upper metal-containing member 2 was 68% of the area of the bonding sheet and 68% of the central region 1B of the bonding sheet 1, and the entire surface of the metal portion was in contact with the central region 1B of the bonding sheet.

The dielectric breakdown voltage (BDV) of the bonding sheet 1 after the thermal cycle test was confirmed to be less than 5 kV.

After the thermal cycle test, the bonding sheet 1 was observed using the ultrasonic imaging system for cracks or deformations due to temperature changes after the production, as well as for the interface between the metal portions (upper metal-containing member 2 and lower metal-containing member 3) and the bonding sheet 1. Cracks and deformations were found, and peeling was also observed at the interface.

### <Measurement and Evaluation Methods of Physical Properties>

Physical properties of the bonded bodies produced in Example I-1 and Comparative Examples I-1 to I-2 were measured and evaluated as follows.

### (Cross-Sectional SEM Imaging)

A bonding sheet was produced in the same conditions as those of the bonding sheet 1 used in the bonded body produced in each of Example I-1 and Comparative Examples I-1 to I-2. Specifically, a part of each thermosetting sheet 1a was heat-pressed under a load of 2 MPa for 5 minutes at 80°C (product temperature), and subsequently heat-pressed under a load of 6 MPa for 30 minutes at 180°C (product temperature) to produce a bonding sheet (measurement sample) having a region pressurized twice and a region not pressurized twice.

The bonded sheet (measurement sample) was cut at an appropriate location in the thickness direction along the width direction (lateral direction) using a shearing machine (DSW3500P (manufactured by Meiwafosis Co., Ltd.)), and the resulting cross-section was used. Cross-sectional processing was performed on an arbitrary location of the cross-section of each sheet by ion milling (using a cross-section polisher SM-09010, manufactured by JEOL Ltd.). Thereafter, the cross-section of each sheet was observed using a SEM scanning electron microscope (SU5000 (manufactured by Hitachi, Ltd.)) at an acceleration voltage of 10 kV and a magnification of 300 times to obtain an SEM image.

### (Method for Calculating Resin Area Ratio)

To calculate the resin area ratio, an area of 300 µm × 165 µm at an arbitrary location was clipped from the SEM image obtained above, and the image on the area was analyzed using image analysis software. Specifically, the clipped image was binarized, and the areas corresponding to the copper plate, inorganic filler, resin (i.e., the portion composed of high-molecular-weight epoxy resin, polyfunctional epoxy resin, biphenyl-type solid epoxy resin, phenol resin-based curing agent, and curing catalyst), and voids were segmented based on the contrast differences. The filler area ratio (%) was then calculated by dividing the area corresponding to the resin by the total area of the inorganic filler, resin, and voids, and multiplying the result by 100. The resin area ratios (%) in the end region 1A and the central region 1B were each shown as the average value of two fields of view.

### (Method for Calculating Void Area Ratio)

To calculate the void area ratio, an area of 300 µm × 165 µm at an arbitrary location was clipped from the SEM image obtained above, and the image on the area was analyzed using image analysis software. Specifically, the clipped image was binarized, and the areas corresponding to the copper plate, inorganic filler, resin (i.e., the portion composed of high-molecular-weight epoxy resin, polyfunctional epoxy resin, biphenyl-type solid epoxy resin, phenol resin-based curing agent, and curing catalyst), and voids were segmented based on the contrast differences. The filler area ratio (%) was then calculated by dividing the area corresponding to the voids by the total area of the inorganic filler, resin, and voids, and multiplying the result by 100. The void area ratios (%) in the end region 1A and the central region 1B were each shown as the average value of two fields of view.

### (Method for Calculating Void Average Size)

An area of 300 µm × 165 µm at an arbitrary location was clipped from the SEM image obtained in the same manner as above, and the area (µm²) corresponding to the voids obtained as described above was divided by the number of voids in the same region to determine the average size of the voids. The void average sizes (µm²/number) in the end region 1A and the central region 1B were each shown as the average value (µm²/number) of two fields of view.

### (Measurement of Dielectric Breakdown Voltage (BDV))

The bonded body obtained in each of Example I-1 and Comparative Examples I-1 to I-2 was immersed in Fluorinert FC-40 (manufactured by 3M), and a voltage application jig was set up such that a voltage was applied between the metal portion 25 of the upper metal-containing member 2 and the lower metal-containing member 3. Using an ultra-high voltage withstand voltage tester 7470 (manufactured by Keisoku Giken Co., Ltd.), a voltage of 0.5 kV was applied to the region 1A of the bonding sheet 1, and the voltage was increased by 0.5 kV every 60 seconds. The dielectric breakdown voltage (BDV) was measured to confirm whether or not the dielectric breakdown voltage (BDV) was 5 kV or more.

### (Measurement of Thermal Conductivity)

A bonding sheet was produced in the same conditions as those of the bonding sheet 1 used in the bonded body produced in Example I-1. Specifically, the thermosetting sheet 1a was heat-pressed under a load of 2 MPa for 5 minutes at 80°C (product temperature), and subsequently heat-pressed under a load of 6 MPa for 30 minutes at 180°C (product temperature) to produce a bonding sheet (measurement sample) that was pressurized twice.

The thermal conductivity of the bonding sheet (measurement sample) was measured using a "T3ster DynTIM Tester" manufactured by Mentor Graphics Corp.

Four types of sheets with different thicknesses were prepared by laminating two, three, and four bonding sheets (measurement samples) respectively. The thickness, area, and thermal resistance of these sheets were measured, and the thermal conductivity (at 25°C) in the sheet thickness direction using the steady-state method was determined from the slope represented by the thermal resistance values relative to the sheet thicknesses (in accordance with ASTM D5470).

In the measurement, the probe size was φ12.8 mm, the fixing pressure was 3,400 kPa, and the measurement time was 300 seconds. To improve the adhesion between the sample and the probe, Oil Compound (Product Name: G-747) manufactured by Shin-Etsu Chemical Co., Ltd. was used.

### (Observation of Cracks, Deformations, and Interfaces)

The bonded bodies produced in Example I-1 and Comparative Examples I-1 to I-2 were each observed using an ultrasonic imaging system FinSAT (FS300III) manufactured by Hitachi Power Solutions Co., Ltd., to examine the presence or absence of cracks or deformations in the bonding sheet 1, as well as the interface between the metal portions (upper metal-containing member 2 and lower metal-containing member 3) and the bonding sheet 1. The measurements were performed using a probe with a frequency of 50 MHz, a gain of 30 dB, and a pitch of 0.2 mm, with the bond bodies (samples) placed in water. These results are designated as the observation results for the presence or absence of cracks or deformations and the interface conditions during the production.

### (Thermal Cycle Test)

The bonded bodies produced in Example I-1 and Comparative Examples I-1 to I-2 were each subjected to a thermal cycle test using a thermal shock chamber TSA-41L-A (manufactured by Espec Corp.). The test conditions were as follows: starting at room temperature, cooling to -40°C and holding for 30 minutes, returning to room temperature, heating to 150°C (product temperature) and holding for 30 minutes, and then returning to room temperature. This cycle was performed 100 times.

After the thermal cycle test, the dielectric breakdown voltage (BDV) was measured in the same manner as above to confirm whether or not the dielectric breakdown voltage (BDV) was 5 kV or more.

In addition, after the thermal cycle test, the bonded bodies were each observed using the ultrasonic imaging system in the same manner as above to examine the presence or absence of cracks or deformations in the bonding sheet 1, as well as the interface between the metal portions (upper metal-containing member 2 and lower metal-containing member 3) and the bonding sheet 1. These results are designated as the observation results for the presence or absence of cracks or deformations and the interface conditions due to temperature changes after the production.

### (Discussion)

From the results of the above Example I-1 and Comparative Examples I-1 to I-2, as well as test results previously conducted by the present inventors, it was found that in the bonded body including the upper metal-containing member 2 and the lower metal-containing member 3 bonded, respectively, to the upper and lower surfaces of the bonding sheet 1, cracks and deformations in the bonding sheet 1 can be suppressed, even when stress is applied to the bonding sheet 1 due to a difference in expansion coefficients between the members caused by temperature changes, by: setting the value of P_{1A}/P_{1B} to more than 1.10, where P_{1A} is the resin area ratio in the end region 1A extending 300 µm inward from either the left or right end of the bonding sheet 1, and P_{1B} is the resin area ratio in the central region 1B other than the end region 1A; or setting the value of S_{1A}/S_{1B} to more than 1, where S_{1A} is the void area ratio in the end region 1A extending 300 µm inward from either the left or right end of the bonding sheet 1, and S_{1B} is the void area ratio in the central region 1B other than the end region 1A, when the bonding sheet 1 is viewed in cross-section; or setting the value of L_{1A}/L_{1B} to more than 2, where L_{1A} is the void average size in the end region 1A extending 300 µm inward from either the left or right end of the bonding sheet 1, and L_{1B} is the void average size in the central region 1B other than the end region 1A, when the bonding sheet 1 is viewed in cross-section.

It is presumed that, by setting the value of P_{1A}/P_{1B} to more than 1.10, i.e., increasing the resin ratio in the end region 1A of the bonding sheet 1, the stress relaxation effect can be enhanced, thereby suppressing cracks and deformations in the bonding sheet 1 even when stress is applied to the bonding sheet 1 due to a difference in expansion coefficients between the members caused by temperature changes in tests or mounting processes where stress concentrates particularly at the end of the bonding sheet 1.

It is also presumed that, by setting the value of S_{1A}/S_{1B} to more than 1, the voids act as a buffer to enhance the stress relaxation effect, thereby suppressing cracks and deformations in the bonding sheet 1 even when stress is applied to the bonding sheet 1 due to a difference in expansion coefficients between the members caused by temperature changes in tests or mounting processes where stress concentrates particularly at the end of the bonding sheet 1.

Furthermore, it is presumed that, by setting the value of L_{1A}/L_{1B} to more than 2, cracks and deformations in the bonding sheet 1 can be suppressed even when stress is applied to the bonding sheet 1 due to a difference in expansion coefficients between the members caused by temperature changes in tests or mounting processes where stress concentrates particularly at the end of the bonding sheet 1.

Based on the above mechanisms of action, it is believed that the present invention achieves the object of suppressing cracks and deformations in the bonding sheet 1 by satisfying at least one of the three requirements, even when stress is applied to the bonding sheet 1 due to a difference in expansion coefficients between the members caused by temperature changes.

### <Examples and Comparative Examples of Present Bonded Body II>

Example II-1 and Comparative Example II-1 of the present bonded body II will be described below.

### (Upper Metal-Containing Member 12)

As the upper metal-containing member 12, a member having dimensions of 21 mm in length, 16 mm in width, and 5 mm in thickness was provided, in which the periphery, excluding the bottom surface, of a copper plate serving as the metal portion 121 and having dimensions of 16 mm in length, 13 mm in width, and 2 mm in thickness was coated with epoxy resin serving as the resin 122.

### (Lower Metal-Containing Member 13)

As the lower metal-containing member 13, a copper plate having dimensions of 40 mm in length, 80 mm in width, and 2 mm in thickness was provided.

### (Bonding Sheet 11)

The following components were mixed using a planetary centrifugal mixer by adding methyl ethyl ketone and cyclohexanone to achieve a solid content concentration of 74% by mass, thereby preparing a slurry-form thermosetting resin composition: 9 parts by mass of high-molecular-weight epoxy resin (mass average molecular weight in polystyrene equivalent: 30,000, epoxy equivalent: 9,000 g/eq, density: approximately 1.2 g/cm³); 7 parts by mass of polyfunctional epoxy resin containing a structure with four or more glycidyl groups per molecule (molecular weight: 500 or less; density: approximately 1.2 g/cm³); 15 parts by mass of biphenyl-type solid epoxy resin (molecular weight: approximately 400, density: approximately 1.2 g/cm³); 63 parts by mass of spherical boron nitride agglomerated particles having a card-house structure (average particle diameter (D50): 45 µm, maximum particle diameter (Dmax): 90 µm); 5 parts by mass of a phenol resin-based curing agent, 0.4 parts by mass of a curing catalyst (2,4-diamino-6-[2'-ethyl-4'-methylimidazolyl-(17')]-ethyl-s-triazine, molecular weight: 247, properties: solid, melting point: 215°C to 225°C); and 0.4 parts by mass of a curing catalyst (2-phenyl-4,5-dihydroxymethylimidazole, molecular weight: 204; properties: solid; melting point: dec. 230, thus 230°C or higher).

The maximum particle diameter (Dmax) and the average particle diameter (D50) of the boron nitride agglomerated particles were the maximum particle diameter Dmax and the 50% cumulative volume particle diameter (average particle diameter D50) determined from the volume-based particle size distribution, which was obtained using a laser diffraction/scattering particle size analyzer LA-300 (manufactured by Horiba, Ltd.) after dispersing the boron nitride agglomerated particles in a pure water medium containing sodium hexametaphosphate as a dispersion stabilizer.

The slurry-form thermosetting resin composition obtained as described above was coated onto a PET substrate using the doctor blade method, and after heat-drying at 60°C (ambient temperature) for 120 minutes, a pressure was applied thereon using a press machine at 42°C (product temperature) and 1,500 kgf/cm² for 10 minutes to obtain a sheet-form resin composition with dimensions of 200 mm in length, 200 mm in width, and 150 µm in thickness (referred to as "the thermosetting sheet 11a").

The total content of methyl ethyl ketone and cyclohexanone in the thermosetting sheet 11a was 1% by mass or less.

The thermosetting sheet 11a obtained above was subjected to low-temperature aging in a freezer at -20°C for two days without applying any specific load, thereby obtaining a thermosetting sheet 11a.

### <Example II-1>

Using the aforementioned upper metal-containing member 12, lower metal-containing member 13, and thermosetting sheet 11a, a bonded body was produced as follows.

The thermosetting sheet 11a was laminated on the lower metal-containing member 13 to form a laminate, and copy paper was placed on the top and bottom of the laminate, respectively. The resulting laminate was set in a press machine with the upper and lower platens pre-heated to 80°C, and then heat-pressed at 80°C (product temperature) under a load of 2 MPa for 5 minutes.

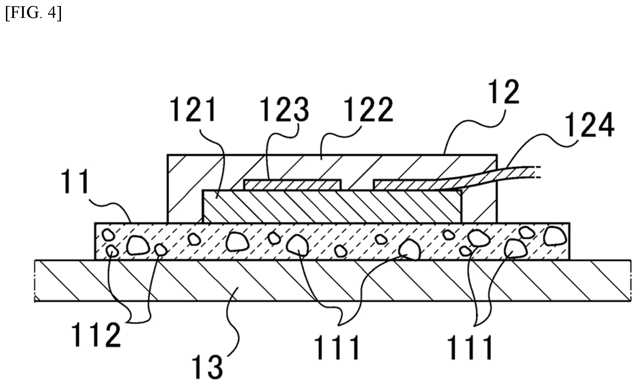

Subsequently, the upper metal-containing member 12 was laminated on the thermosetting sheet 11a, which had been laminated on the lower metal-containing member 13, to form a laminate, and copy paper was further placed on the top and bottom of the laminate, respectively. The resulting laminate was set in a press machine with the upper and lower platens pre-heated to 180°C, and then heat-pressed at 180°C (product temperature) under a load of 6 MPa for 30 minutes, thereby obtaining a bonded body including the upper metal-containing member 12 and the lower metal-containing member 13 bonded, respectively, to the upper and lower surfaces of the bonding sheet 11 having a thickness of 150 µm, and having a region 11A and a region 11B, as shown in FIGS. 3 and 4.

The cross-sections of the region 11A and the region 11B of the bonding sheet 11 were observed using the scanning electron microscope (SEM). The presence of voids was confirmed in both the regions 11A and 11B.

The area ratio of voids present in the region 11A of the bonding sheet 11 (void ratio X_{A}) was 0.032%, and the area ratio of voids present in the region 11B (void ratio X_{B}) was 7.2%. The value of X_{B}/X_{A} was more than 2.0.

The storage elastic modulus Y_{A} at 200°C in the region 11A was 5.54 × 10⁹ Pa, and the storage elastic modulus Y_{B} at 200°C in the region 11B was 3.98 × 10⁹ Pa. The value of Y_{B}/Y_{A} was 0.8 or less.

The dielectric breakdown voltage (BDV) in the region 11A of the bonding sheet 11 was confirmed to be 5 kV or more.

The thermal conductivity in the thickness direction in the region 11A of the bonding sheet 11 was 14 W/m·K.

The bonding sheet 11 was observed visually and using the ultrasonic imaging system during and after the production of the bonded body for cracks or deformations in the peripheral region 11B surrounding the region 11A. Neither cracks nor deformations were observed.

### <Comparative Example II-1>

In the production of the aforementioned thermosetting sheet 11a, aging was performed in a 60°C environment for 3 days, instead of the low-temperature aging in a freezer at -20°C for 2 days, to obtain a thermosetting sheet. A bonded body was then produced in the same manner as in Example II-1, except that the thermosetting sheet was used.

The cross-sections of the region 11A and the region 11B of the bonding sheet 11 were observed using the scanning electron microscope (SEM). The presence of voids was confirmed in both the regions 11A and 11B.

The storage elastic modulus at 200°C in the region 11A was 3.02 × 10⁹ Pa, and the storage elastic modulus at 200°C in the region 11B was 3.91 × 10⁹ Pa.

The bonding sheet 11 was observed visually and using the ultrasonic imaging system during and after the production of the bonded body for cracks or deformations in the peripheral region 11B surrounding the region 11A. Cracks and deformations were observed.

### <Measurement and Evaluation Methods of Physical Properties>

Physical properties of the bonded bodies produced in Example II-1 and Comparative Example II-1 were measured and evaluated as follows.

### (Cross-Sectional SEM Imaging)

A bonding sheet was produced in the same conditions as those of the bonding sheet 11 used in the bonded body produced in Example II-1. Specifically, a part of the thermosetting sheet 11a was heat-pressed under a load of 2 MPa for 5 minutes at 80°C (product temperature), and subsequently heat-pressed under a load of 6 MPa for 30 minutes at 180°C (product temperature) to produce a bonding sheet (measurement sample) having a region 11A pressurized twice and a region 11B not pressurized twice.

The bonded sheet (measurement sample) was cut at an appropriate location in the thickness direction along the width direction (lateral direction) using a shearing machine (DSW3500P (manufactured by Meiwafosis Co., Ltd.)), and the resulting cross-section was used. Cross-sectional processing was performed on an arbitrary location of the sheet cross-section by ion milling (using a cross-section polisher SM-09010, manufactured by JEOL Ltd.). Thereafter, the cross-section was observed using a SEM scanning electron microscope (SU5000 (manufactured by Hitachi, Ltd.)) at an acceleration voltage of 10 kV and a magnification of 500 times to obtain an SEM image.

### (Method for Calculating Void Ratio)

To calculate the void ratio, an area of 254 µm × 75 µm at an arbitrary location was clipped from the SEM image obtained above, and the image on the area was analyzed using image analysis software. Specifically, the clipped image was binarized, and the areas with a contrast higher than that of the sheet components, which are the inorganic filler and resin (i.e., the portion composed of high-molecular-weight epoxy resin, polyfunctional epoxy resin, biphenyl-type solid epoxy resin, phenol resin-based curing agent, and curing catalyst), were extracted as voids. The total area was divided by the clipped area of 254 µm × 75 µm, and the result was multiplied by 100 to obtain the area ratio of voids, that is, the void ratio (%). The area ratios of voids present in the regions 11A and 11B, that is, the void ratio X_{A} (%) and the void ratio X_{B} (%), were each shown as the average value of five fields of view. The results for Example II-1 are shown in Table 1.

**[Table 1]**

| | Region 11A | Region 11B |
|---|---|---|
| | Void ratio X_{A} | Void ratio X_{B} |
| | (%) | (%) |
| View 1 | 0.041 | 3.7 |
| View 2 | 0.036 | 7.1 |
| View 3 | 0.017 | 11.1 |
| View 4 | 0.002 | 5.7 |
| View 5 | 0.062 | 8.5 |
| Average | 0.032 | 7.2 |

### (Method for Calculating Average Void Area)

An area of 254 µm × 75 µm at an arbitrary location was clipped from the SEM image obtained in the same manner as above, and the image on the area was analyzed using image analysis software. Specifically, the clipped image was binarized, and the areas with a contrast higher than that of the sheet components, which are the inorganic filler and resin (i.e., the portion composed of high-molecular-weight epoxy resin, polyfunctional epoxy resin, biphenyl-type solid epoxy resin, phenol resin-based curing agent, and curing catalyst), were extracted as voids. The total area of the extracted voids at the arbitrary location was divided by the number of voids to determine the average void area of the voids. The average void areas (µm²) in the regions 11A and 11B were each shown as the average value of five fields of view. The results for Example II-1 are shown in Table 2.

**[Table 2]**

| | Region 11A | Region 11B |
|---|---|---|
| | Average void area | Average void area |
| | (µm²) | (µm²) |
| View 1 | 0.965 | 140 |
| View 2 | 1.713 | 169 |
| View 3 | 0.788 | 352 |
| View 4 | 0.433 | 217 |
| View 5 | 2.378 | 404 |
| Average | 1.255 | 256 |

### (Method for Measuring Storage Elastic Modulus)

A bonding sheet was produced in the same conditions as those of the bonding sheet 11 used in the bonded body produced in each of Example II-1 and Comparative Example II-1. Specifically, a part of each thermosetting sheet 11a was heat-pressed under a load of 2 MPa for 5 minutes at 80°C (product temperature), and subsequently heat-pressed under a load of 6 MPa for 30 minutes at 180°C (product temperature) to produce a bonding sheet (measurement sample) having a region 11A pressurized twice and a region 11B not pressurized twice.

The regions 11A and 11B of the bonding sheet (measurement sample) were each cut out to dimensions of 3 to 10 mm in width, 50 to 60 mm in length, and 0.3 to 0.6 mm in thickness, and the storage elastic moduli at 200°C of the regions 11A and 11B were measured under the conditions of a chuck distance of 35 mm, a temperature rise rate of 2°C/min from -150°C to 260°C, and a measurement frequency of 1 Hz. The measurement apparatus used was EXSTAR 6000 DMS 6100.

### (Observation of Voids)

The regions 11A and 11B of the bonded body produced in each of Example II-1 and Comparative Example II-1 were each cut at an appropriate location in the thickness direction along the width direction (lateral direction) using a shearing machine (DSW3500P (manufactured by Meiwafosis Co., Ltd.)). Cross-sectional processing was performed on an arbitrary location of each sheet cross-section by ion milling (using a cross-section polisher SM-09010, manufactured by JEOL Ltd.). The cross-section was observed using a SEM scanning electron microscope (SU5000 (manufactured by Hitachi, Ltd.)) at an acceleration voltage of 10 kV and a magnification of 300 times.

### (Measurement of Dielectric Breakdown Voltage (BDV))

The bonded body produced in Example II-1 was immersed in Fluorinert FC-40 (manufactured by 3M), and a voltage application jig was set up such that a voltage was applied between the metal portion 121 of the upper metal-containing member 12 and the lower metal-containing member 13. Using an ultra-high voltage withstand voltage tester 7470 (manufactured by Keisoku Giken Co., Ltd.), a voltage of 0.5 kV was applied to the region 11A of the bonding sheet 11, and the voltage was increased by 0.5 kV every 60 seconds. The dielectric breakdown voltage (BDV) was measured to confirm whether or not the dielectric breakdown voltage (BDV) was 5 kV or more.

### (Measurement of Thermal Conductivity)

A bonding sheet was produced in the same conditions as those of the bonding sheet 11 used in the bonded body produced in Example II-1. Specifically, a part of the thermosetting sheet 11a was heat-pressed under a load of 2 MPa for 5 minutes at 80°C (product temperature), and subsequently heat-pressed under a load of 6 MPa for 30 minutes at 180°C (product temperature) to produce a bonding sheet (measurement sample) having a region 11A pressurized twice.

The thermal conductivity in the region 11A of the bonding sheet (measurement sample) was measured using a "T3ster DynTIM Tester" manufactured by Mentor Graphics Corp.

Four types of sheets with different thicknesses were prepared by laminating two, three, and four bonding sheets (measurement samples) respectively. The thickness, area, and thermal resistance of these sheets were measured, and the thermal conductivity (at 25°C) in the sheet thickness direction using the steady-state method was determined from the slope represented by the thermal resistance values relative to the sheet thicknesses (in accordance with ASTM D5470).

In the measurement, the probe size was φ12.8 mm, the fixing pressure was 3,400 kPa, and the measurement time was 300 seconds. To improve the adhesion between the sample and the probe, Oil Compound (Product Name: G-747) manufactured by Shin-Etsu Chemical Co., Ltd. was used.

### (Observation of Cracks and Deformations)

The bonded bodies produced in Example II-1 and Comparative Example II-1 were visually observed from above or from an oblique upper direction to examine the presence or absence of cracks or deformations in the peripheral region 11B surrounding the region 11A of each bonding sheet 11 during and after the production of the bonded bodies.

In addition, the bonded bodies produced in Example II-1 and Comparative Example II-1 were observed using an ultrasonic imaging system FinSAT (FS300III) manufactured by Hitachi Power Solutions Co., Ltd., to examine the presence or absence of cracks or deformations in the peripheral region 11B surrounding the region 11A of each bonding sheet 11 during and after the production of the bonded bodies. The measurements were performed using a probe with a frequency of 50 MHz, a gain of 30 dB, and a pitch of 0.2 mm, with the bond bodies (samples) placed in water.

### (Discussion)

From the results of the above Example II-1 and Comparative Example II-1, as well as test results previously conducted by the present inventors, it was found that in the bonded body including the upper metal-containing member 12 and the lower metal-containing member 13 bonded, respectively, to the upper and lower surfaces of the bonding sheet 11, local pressure concentration in the region 11B of the bonding sheet 11 can be suppressed, and cracks and deformations in the region 11B can be eliminated during and after the production of the bonded body, by: making the area ratio of voids present in the region 11B of the bonding sheet 11 (void ratio X_{B}) larger than the area ratio of voids present in the region 11A (void ratio X_{A}); or making the storage elastic modulus Y_{B} at 200°C in the region 11B of the bonding sheet 11 smaller than the storage elastic modulus Y_{A} at 200°C in the region 11A.

### <Examples and Comparative Examples of Present Bonded Body III>

Example III-1 and Comparative Examples III-1 to IIII-2 of the present bonded body III will be described below.

### (Upper Metal-Containing Member 22)

As the upper metal-containing member 22, two members each having dimensions of 21 mm in length, 16 mm in width, and 5 mm in thickness were provided, in which the periphery, excluding the bottom surface, of a copper plate serving as the metal portion 221 and having dimensions of 16 mm in length, 13 mm in width, and 2 mm in thickness was coated with epoxy resin serving as the resin 222.

### (Lower Metal-Containing Member 23)

As the lower metal-containing member 23, a copper plate having dimensions of 40 mm in length, 80 mm in width, and 2 mm in thickness was provided.

### (Bonding Sheet 21)

The following components were mixed using a planetary centrifugal mixer by adding methyl ethyl ketone and cyclohexanone to achieve a solid content concentration of 74% by mass, thereby preparing a slurry-form thermosetting resin composition: 9 parts by mass of high-molecular-weight epoxy resin (mass average molecular weight in polystyrene equivalent: 30,000, epoxy equivalent: 9,000 g/eq, density: approximately 1.2 g/cm³); 7 parts by mass of polyfunctional epoxy resin containing a structure with four or more glycidyl groups per molecule (molecular weight: 500 or less; density: approximately 1.2 g/cm³); 15 parts by mass of biphenyl-type solid epoxy resin (molecular weight: approximately 400, density: approximately 1.2 g/cm³); 63 parts by mass of spherical boron nitride agglomerated particles having a card-house structure (average particle diameter (D50): 45 µm, maximum particle diameter (Dmax): 90 µm); 5 parts by mass of a phenol resin-based curing agent, 0.4 parts by mass of a curing catalyst (2,4-diamino-6-[2'-ethyl-4'-methylimidazolyl-(17')]-ethyl-s-triazine, molecular weight: 247, properties: solid, melting point: 215°C to 225°C); and 0.4 parts by mass of a curing catalyst (2-phenyl-4,5-dihydroxymethylimidazole, molecular weight: 204; properties: solid; melting point: dec. 230, thus 230°C or higher).

The maximum particle diameter (Dmax) and the average particle diameter (D50) of the boron nitride agglomerated particles were the maximum particle diameter Dmax and the 50% cumulative volume particle diameter (average particle diameter D50) determined from the volume-based particle size distribution, which was obtained using a laser diffraction/scattering particle size analyzer LA-300 (manufactured by Horiba, Ltd.) after dispersing the boron nitride agglomerated particles in a pure water medium containing sodium hexametaphosphate as a dispersion stabilizer.

The slurry-form thermosetting resin composition obtained as described above was coated onto a PET substrate using the doctor blade method, and after heat-drying at 60°C (ambient temperature) for 120 minutes, a pressure was applied thereon using a press machine at 42°C (product temperature) and 1,500 kgf/cm² for 10 minutes to obtain a sheet-form resin composition with dimensions of 200 mm in length, 200 mm in width, and 150 µm in thickness (referred to as "the thermosetting sheet 21a").

The total content of methyl ethyl ketone and cyclohexanone in the thermosetting sheet 21a was 1% by mass or less.

The thermosetting sheet 21a obtained above was subjected to low-temperature aging in a freezer at -20°C for two days without applying any specific load, thereby obtaining a thermosetting sheet 21a.

### <Example III-1>

Using the aforementioned two upper metal-containing members 22, lower metal-containing member 23, and thermosetting sheet 21a, a bonded body was produced as follows.

The thermosetting sheet 21a was laminated on the lower metal-containing member 23 to form a laminate, and copy paper was placed on the top and bottom of the laminate, respectively. The resulting laminate was set in a press machine with the upper and lower platens pre-heated to 80°C, and then heat-pressed at 80°C (product temperature) under a load of 2 MPa for 5 minutes.

Subsequently, the two upper metal-containing members 22 were laminated side-by-side on the thermosetting sheet 21a with a distance of 15 mm between them to form a laminate, and copy paper was further placed on the top and bottom of the laminate, respectively. The resulting laminate was set in a press machine with the upper and lower platens pre-heated to 180°C, and then heat-pressed at 180°C (product temperature) under a load of 6 MPa for 30 minutes, thereby obtaining a bonded body having a region 21A and a region 21B, in which the two upper metal-containing members 22 were bonded to the upper surface of the bonding sheet 21 having a thickness of 150 µm via a space portion 24 with a width of 15 mm, and the lower metal-containing member 23 was bonded to the lower surface of the bonding sheet 21, as shown in FIGS. 5 and 6.

The cross-sections of the region 21A and the region 21B in the bonding sheet 21 were observed using the scanning electron microscope (SEM). The presence of voids was confirmed in both the regions 21A and 21B.

The thickness T_{A} of the region 21A in the bonding sheet 21 was 137 µm, the thickness T_{B} of the region 21B was 156 µm, the ratio of the two (T_{B}/T_{A}) was 1.14, and the difference between the two (T_{B} - T_{A}) was 19 µm.

The dielectric breakdown voltage (BDV) in the region 21A of the bonding sheet 21 was confirmed to be 5 kV or more.

The thermal conductivity in the thickness direction in the region 21A of the bonding sheet 21 was 14 W/m·K.

### <Comparative Example III-1>

In the production of the aforementioned thermosetting sheet 21a, aging was performed in a 100°C environment for 1 hour, instead of the low-temperature aging in a freezer at -20°C for 2 days, to obtain a thermosetting sheet. A bonded body was then produced in the same manner as in Example III-1, except that the thermosetting sheet was used.

The cross-sections of the region 21A and the region 21B of the bonding sheet 21 were observed using the scanning electron microscope (SEM). The presence of voids was confirmed in both the regions 21A and 21B.

The thickness T_{A} of the region 21A in the bonding sheet 21 was 157 µm, the thickness T_{B} of the region 21B was 159 µm, the ratio of the two (T_{B}/T_{A}) was 1.01, and the difference between the two (T_{B} - T_{A}) was 2 µm.

The dielectric breakdown voltage (BDV) in the region 21A of the bonding sheet 21 was confirmed to be 1.5 kV (less than 5 kV).

### <Comparative Example III-2>

In the production of the aforementioned thermosetting sheet 21a, aging was performed in a 60°C environment for 3 days, instead of the low-temperature aging in a freezer at -20°C for 2 days, to obtain a thermosetting sheet. A bonded body was then produced in the same manner as in Example III-1, except that the thermosetting sheet was used.

The cross-sections of the region 21A and the region 21B of the bonding sheet 21 were observed using the scanning electron microscope (SEM). The presence of voids was confirmed in both the regions 21A and 21B.

The thickness T_{A} of the region 21A in the bonding sheet 21 was 157 µm, the thickness T_{B} of the region 21B was 158 µm, the ratio of the two (T_{B}/T_{A}) was 1.01, and the difference between the two (T_{B} - T_{A}) was 1 µm.

The dielectric breakdown voltage (BDV) in the region 21A of the bonding sheet 21 was confirmed to be 1.5 kV (less than 5 kV).

### <Measurement and Evaluation Methods of Physical Properties>

Physical properties of the bonded bodies produced in Example III-1 and Comparative Examples III-1 to III-2 were measured and evaluated as follows.

### (Measurement of Thicknesses of Regions 21A and 21B)

The thicknesses of the regions 21A and 21B in the bonded body obtained in each of Example III-1 and Comparative Examples III-1 to III-2 were each measured at an appropriate location using a digital micrometer.

### (Observation of Voids)

The regions 21A and 21B of the bonded body produced in each of Example III-1 and Comparatives Example III-1 to III-2 were each cut at an appropriate location in the thickness direction along the width direction (lateral direction) using a shearing machine (DSW3500P (manufactured by Meiwafosis Co., Ltd.)). Cross-sectional processing was performed on an arbitrary location of each sheet cross-section by ion milling (using a cross-section polisher SM-09010, manufactured by JEOL Ltd.). The cross-section was observed using a SEM scanning electron microscope (SU5000 (manufactured by Hitachi, Ltd.)) at an acceleration voltage of 10 kV and a magnification of 300 times.

### (Measurement of Dielectric Breakdown Voltage (BDV))

The bonded body produced in each of Example III-1 and Comparative Examples III-1 to III-2 was immersed in Fluorinert FC-40 (manufactured by 3M), and a voltage application jig was set up such that a voltage was applied between the metal portion 221 of each of the upper metal-containing members 22 and the lower metal-containing member 23. Using an ultra-high voltage withstand voltage tester 7470 (manufactured by Keisoku Giken Co., Ltd.), a voltage of 0.5 kV was applied to the region 21A of the bonding sheet 21, and the voltage was increased by 0.5 kV every 60 seconds. The dielectric breakdown voltage (BDV) was measured to confirm whether or not the dielectric breakdown voltage (BDV) was 5 kV or more.

### (Measurement of Thermal Conductivity)

A bonding sheet was produced in the same conditions as those of the bonding sheet 21 used in the bonded body produced in Example III-1. Specifically, a part of the thermosetting sheet 21a was heat-pressed under a load of 2 MPa for 5 minutes at 80°C (product temperature), and subsequently heat-pressed under a load of 6 MPa for 30 minutes at 180°C (product temperature) to produce a bonding sheet (measurement sample) having a region 21A pressurized twice.

The thermal conductivity in the region 21A of the bonding sheet (measurement sample) was measured using a "T3ster DynTIM Tester" manufactured by Mentor Graphics Corp.

Four types of sheets with different thicknesses were prepared by laminating two, three, and four bonding sheets (measurement samples) respectively. The thickness, area, and thermal resistance of these sheets were measured, and the thermal conductivity (at 25°C) in the sheet thickness direction using the steady-state method was determined from the slope represented by the thermal resistance values relative to the sheet thicknesses (in accordance with ASTM D5470).

In the measurement, the probe size was φ12.8 mm, the fixing pressure was 3,400 kPa, and the measurement time was 300 seconds. To improve the adhesion between the sample and the probe, Oil Compound (Product Name: G-747) manufactured by Shin-Etsu Chemical Co., Ltd. was used.

### (Discussion)

From the results of the above Example III-1 and Comparative Examples III-1 to III-2, as well as test results previously conducted by the present inventors, it was found that by bonding the two or more upper metal-containing members 22 to the bonding sheet 21 with the space portion 24 provided between the adjacent upper metal-containing members 22, and by providing a step difference such that the interface 22a between each of the upper metal-containing members 22 and the bonding sheet 21 is positioned below the creepage surface 24a of the space portion 24, the thickness T_{B} of the region 21B in the bonding sheet 21 that is not bonded to each of the upper metal-containing members 22, i.e., the region 21B of the bonding sheet 21 at the space portion 24, can be made larger than the thickness T_{A} of the region 21A in the bonding sheet 21 that is bonded to each of the upper metal-containing members 22, and preferably, the ratio (T_{B}/T_{A}) of the thickness T_{B} of the region 21B to the thickness T_{A} of the region 21A can be made 1.02 or more, which allows a conduction distance (creepage distance) between the metal portion of one upper metal-containing member 22 and the metal portion of the adjacent upper metal-containing member 22 to be made longer by a length of (T_{B} - T_{A}) × 2.

If the conduction distance (creepage distance) between the metal portion of one upper metal-containing member 22 and the metal portion of the adjacent upper metal-containing member 22 becomes short, creepage discharge occurs, which results in the deterioration of the bonding sheet 21 and a subsequent decrease in the dielectric breakdown voltage (BDV). In contrast, by increasing the conduction distance (creepage distance) between the metal portion of one upper metal-containing member 22 and the metal portion of the adjacent upper metal-containing member 22 as described above, a decrease in the dielectric breakdown voltage (BDV) can be suppressed.

Since the interface 22a between each of the upper metal-containing members 22 and the bonding sheet 21 is positioned below the creepage surface 24a of the space portion 24, the risk of creepage discharge when current is applied to the upper metal-containing members 22 is also expected to decrease. Furthermore, in humid environments, for example, the penetration distance of atmospheric moisture into the bonding interface between the metal portion of each of the upper metal-containing members 22 and the bonding sheet 21 can be increased since the interface 22a between each of the upper metal-containing members 22 and the bonding sheet 21 is positioned below the creepage surface 24a of the space portion 24. This configuration reduces the risk of moisture ingress and is also expected to mitigate the causes of failure.

### EXPLANATIONS OF LETTERS OR NUMERALS

1 Bonding sheet
1A End region
1B Central region
2 Upper metal-containing member
3 Lower metal-containing member
11 Bonding sheet
11A, 11B Regions
12 Upper metal-containing member
13 Lower metal-containing member
14 Inorganic filler
15 Void
21 Bonding sheet
21A, 21B Regions
22 Upper metal-containing member
22a Interface
23 Lower metal-containing member
24 Space portion
24a Creepage surface
25 Metal portion
26 Resin
27 Semiconductor chip
28 Wiring member
100 Bonding sheet
111 Inorganic filler
112 Void
121 Metal portion
122 Resin
123 Semiconductor chip
124 Wiring member
200 Upper metal-containing member
201 Metal portion
202 Resin
211 Inorganic filler
212 Void
221 Metal portion
222 Resin
223 Semiconductor chip
224 Wiring member
300 Lower metal-containing member

## Claims

1. A bonded body, comprising an upper metal-containing member 2 and a lower metal-containing member 3 bonded, respectively, to upper and lower surfaces of a bonding sheet 1,
the upper metal-containing member 2 and the lower metal-containing member 3 each having a metal portion in a bonding surface with the bonding sheet 1,
the bonding sheet 1 being a cured product of a thermosetting resin composition containing a thermosetting resin and an inorganic filler, wherein
the entire upper surface of the bonding sheet 1 is bonded to the upper metal-containing member 2 and the entire lower surface of the bonding sheet 1 is bonded to the lower metal-containing member 3, and when the bonding sheet 1 is viewed in cross-section, a value of P_{1A}/P_{1B} is more than 1.10, where P_{1A} is a resin area ratio in an end region 1A extending 300 µm inward from either the left or right end of the bonding sheet 1, and P_{1B} is a resin area ratio in a central region 1B other than the end region 1A.

2. A bonded body, comprising an upper metal-containing member 2 and a lower metal-containing member 3 bonded, respectively, to upper and lower surfaces of a bonding sheet 1,
the upper metal-containing member 2 and the lower metal-containing member 3 each having a metal portion in a bonding surface with the bonding sheet 1,
the bonding sheet 1 being a cured product of a thermosetting resin composition containing a thermosetting resin and an inorganic filler, wherein
the entire upper surface of the bonding sheet 1 is bonded to the upper metal-containing member 2 and the entire lower surface of the bonding sheet 1 is bonded to the lower metal-containing member 3, and when the bonding sheet 1 is viewed in cross-section, a value of S_{1A}/S_{1B} is more than 1, where S_{1A} is a void area ratio in an end region 1A extending 300 µm inward from either the left or right end of the bonding sheet 1, and S_{1B} is a void area ratio in a central region 1B other than the end region 1A.

3. A bonded body, comprising an upper metal-containing member 2 and a lower metal-containing member 3 bonded, respectively, to upper and lower surfaces of a bonding sheet 1,
the upper metal-containing member 2 and the lower metal-containing member 3 each having a metal portion in a bonding surface with the bonding sheet 1,
the bonding sheet 1 being a cured product of a thermosetting resin composition containing a thermosetting resin and an inorganic filler, wherein
the entire upper surface of the bonding sheet 1 is bonded to the upper metal-containing member 2 and the entire lower surface of the bonding sheet 1 is bonded to the lower metal-containing member 3, and when the bonding sheet 1 is viewed in cross-section, a value of L_{1A}/L_{1B} is more than 2, where L_{1A} is a void average size in an end region 1A extending 300 µm inward from either the left or right end of the bonding sheet 1, and L_{1B} is a void average size in a central region 1B other than the end region 1A.

4. The bonded body according to any one of claims 1 to 3, wherein the bonding sheet 1 is directly bonded to the upper metal-containing member 2, and the bonding sheet 1 is directly bonded to the lower metal-containing member 3.

5. The bonded body according to any one of claims 1 to 3, wherein the upper metal-containing member 2 has a configuration in which a lower surface of a sheet or plate-shaped metal portion 25 is exposed in the bonding surface with the bonding sheet 1, and the metal portion 25 is covered and sealed with a resin 26.

6. The bonded body according to any one of claims 1 to 3, wherein the lower metal-containing member 3 has a plate-shaped or sheet-shaped metal body in the bonding surface with the bonding sheet 1.

7. The bonded body according to any one of claims 1 to 3, wherein the bonding sheet 1 has a thermal conductivity in the thickness direction of 10 W/m·K or more.

8. The bonded body according to any one of claims 1 to 3, wherein the bonding sheet 1 has a dielectric breakdown voltage of 5 kV or more.

9. The bonded body according to any one of claims 1 to 3, wherein the metal portions of the upper metal-containing member 2 and the lower metal-containing member 3 comprise a material containing copper or aluminum.

10. The bonded body according to any one of claims 1 to 3, wherein the inorganic filler contained in the bonding sheet 1 comprises boron nitride agglomerated particles.

11. The bonded body according to claim 10, wherein the boron nitride agglomerated particles have a card-house structure.

12. The bonded body according to any one of claims 1 to 3, wherein the thermosetting resin contained in the bonding sheet 1 comprises epoxy resin.

13. The bonded body according to any one of claims 1 to 3, wherein the bonding sheet 1 has a thickness of 80 µm or more and 300 µm or less.

14. A bonding sheet, being a cured product of a thermosetting resin composition containing a thermosetting resin and an inorganic filler, wherein
when the bonding sheet 1 is viewed in cross-section, at least one of the following conditions is satisfied:
a value of P_{1A}/P_{1B} is more than 1.10, where P_{1A} is a resin area ratio in an end region 1A extending 300 µm inward from either the left or right end of the bonding sheet 1, and P_{1B} is a resin area ratio in a central region 1B other than the end region 1A;
a value of S_{1A}/S_{1B} is more than 1, where S_{1A} is a void area ratio in an end region 1A extending 300 µm inward from either the left or right end of the bonding sheet 1, and S_{1B} is a void area ratio in a central region 1B other than the end region 1A; and
a value of L_{1A}/L_{1B} is more than 2, where L_{1A} is a void average size in an end region 1A extending 300 µm inward from either the left or right end of the bonding sheet 1, and L_{1B} is a void average size in a central region 1B other than the end region 1A.

15. A method for producing the bonded body according to any one of claims 1 to 3, comprising: laminating a thermosetting sheet formed by molding the thermosetting resin composition into a sheet on the lower metal-containing member 3; applying a uniform pressure thereon to bond the lower metal-containing member 3 and the thermosetting sheet together; subsequently laminating the upper metal-containing member 2 on the thermosetting sheet; and applying a uniform pressure thereon to bond the thermosetting sheet and the upper metal-containing member 2 together.

16. The method for producing the bonded body according to claim 15, further comprising: subjecting the thermosetting sheet to low-temperature aging in an environment of -50°C or higher and 0°C or lower before being laminated on the lower metal-containing member 3.
